# EUROPEAN PATENT APPLICATION

(11) **EP 4 822 720 A1**
(43) Date of publication of application: **14.10.2026**
(21) Application number: 25169810.6
(22) Date of filing: 10.04.2025
(51) Int. Cl.: H01F 6/02, H01F 6/06

(54) **SUPERCONDUCTOR STRAND ARRANGEMENT FOR QUENCH PROTECTION**

(71) Applicant: Proxima Fusion GmbH, 81369 München (DE)
(72) Inventor: SLADE, Robert, Aston, Bampton, OX18 2BF (GB); RIVA, Nicolò, Brugg AG 5200 (CH)
(74) Representative: Bardehle Pagenberg Partnerschaft mbB Patentanwälte Rechtsanwälte

(57) **Abstract**

1. A strand arrangement (1), optionally for a superconductor magnetic field coil (2, 2a, 2b), comprising:
- a first plurality of strands (10) of superconductor material, the first plurality of strands comprising:
a first strand (A, A1) of the first plurality of strands with a first end (Ab) and a second end (Ae),
a second strand (B, B1) of the first plurality of strands,
a first ohmic heating material (20) arranged between the first strand (A, A1) of the first plurality of strands and the second strand (B, B1) of the first plurality of strands,
a first insulation material (40, 40a) at least partially enclosing the first plurality of strands;

at least one of:
- an electrical series connection (31-39, 310, 311), connecting the second end (Ae) of the first strand (A, A1) of the first plurality of strands with an end of a further strand (B-H), or
- a first electrical series connection (31) connecting the second end (Ae) of the first strand (A, A1) of the first plurality of strands with a first end (Bb) of the second strand (B, B1) of the first plurality of strands.

## Description

### TECHNICAL FIELD

The present disclosure relates to strand arrangements for superconductors, specifically for use in superconductor magnetic field coils and stellarators while providing quench protection. Strand arrangements may include a plurality of superconductor strands, ohmic heating materials, and insulation materials, with electrical series connections to enhance performance. Additionally, the disclosure pertains to superconductor magnetic field coils with insulated strands and ohmic heating paths, for example double pancake coils or other coils.

### BACKGROUND

In the field of superconducting magnetic field coils, it is common to utilize arrangements of superconducting cables to generate powerful magnetic fields for various applications, including medical imaging, particle accelerators, and energy storage systems. Known systems typically involve the use of high-temperature superconductors, such as rare earth barium copper oxide (ReBCO) tapes, which offer significant advantages in terms of critical temperature and magnetic field strength. These systems often employ superconducting material arranged in coils to achieve the desired magnetic field characteristics. Despite the substantial advances in the field of superconducting technology, several challenges remain, particularly in the areas of quench protection, thermal stability, and efficient electrical connectivity.

Quench protection is a critical aspect of superconducting coil design, as it involves the prevention and management of sudden transitions from the superconducting state to the normal resistive state, known as a quench. When a quench occurs, the superconducting material loses its ability to conduct electricity without resistance, leading to rapid heating and potential damage to the coil. Known systems often employ various methods to mitigate the effects of a quench, such as incorporating metallic stabilizers or using external quench protection circuits. However, these approaches can be complex, costly, and may not always provide adequate protection, particularly in high-field applications where the risk of quench is elevated. Further, quenching may lead to undesired effects such as arcing of a coil. To mitigate such problems, complex systems are needed. For example, systems that require extraction of energy during quench events to a dump resistor lead to increased complexity, for example since dump resistors generate high voltages which the system must account for. This increases both system complexity and testing, for example due to the need for extra current leads and the need for Paschen testing. Thus, the integration of quench protection mechanisms can introduce additional complexity to the coil design, potentially impacting the overall efficiency and performance of the system.

Thus, a need exists for solutions which improve quench protection and/or reduce complexity of systems for quench protection.

It is therefore a technical problem underlying the present invention to provide a superconductive strand arrangement that at least partially overcomes the disadvantages of known systems, particularly in terms of quench protection.

### SUMMARY

The above desire is met at least in part by the embodiments and examples outlined herein.

A first aspect of the invention provides a strand arrangement, optionally for a superconductor magnetic field coil, comprising:
- a first plurality of strands of superconductor material.

The first plurality of strands may comprise: a first strand of the first plurality of strands with a first end and a second end, a second strand of the first plurality of strands, a first ohmic heating material arranged between the first strand of the first plurality of strands and the second strand of the first plurality of strands, a first insulation material at least partially enclosing the first plurality of strands.

The strand arrangement may further comprise at least one of:
- an electrical series connection, connecting the second end of the first strand of the first plurality of strands with an end of a further strand, or
- a first electrical series connection connecting the second end of the first strand of the first plurality of strands with a first end of the second strand of the first plurality of strands.

The further strand may be a strand different from the first strand. The further strand may be from the first plurality of strands or a different strand, for example from a different plurality of strands, for example from a second, third, fourth etc. plurality of strands as explained herein.

Such an arrangement may exhibit improved heat management within the superconductor arrangement, in particular during quenches, which may be facilitated by the ohmic heating material. In case that one of the strands loses superconductive properties, the current may transition to another strand of the first plurality of strand, thereby crossing through the ohmic heating material resulting in localized ohmic heating. This may in turn lead to an increased normal zone propagation velocity along the length of the plurality of strands, in turn leading to enhanced quench behavior. The metallic stabilizer material (see below) may further provide heat capacity and ohmic heating, thus may allow safe dissipation of the energy during a quench.

Such arrangements as described herein may at least in part have the benefits known from non-insulated coils, for example low voltage and safe shutdown in cases where an open circuit arises, for example due to broken joints or quenched superconductors, for example in strands or cables of a coil. At the same time, arrangements as described herein may not have the disadvantages known from non-insulated coils. For example, the arrangements as described herein may allow an improved uniform dumping of the magnetic energy into the mass of the arrangement, for example the stabilizer materials and/or the ohmic heating materials disclosed herein. This may allow an improved control of the localized heating of components in the arrangement. Where multiple arrangements are used, for example in multiple magnetic field coils in a stellarator, this behavior may reduce or even avoid force imbalances during quench events and/or may allow a simultaneous shutdown of a plurality of coils if a quench occurs within a single coil. As explained herein, this may be achieved as the arrangement increases a propagation velocity of the normal zone along the plurality of strands during a quench. Additionally or alternatively, an inductive current transfer in coupled coils formed according to the arrangement may be achieved which further improves the shutdown behavior during a quench. For example, in case a quench the current of the superconductive strands transitioning to a non-superconductive strand may migrate to the ohmic heating material and/or the metallic stabilizer. This transfer may occur due to migration from the strand into the metallic stabilizer material due to the increased resistance of the no-longer superconducting strands and/or due to inductive coupling between adjacent strands, for example between quenching strands and superconducting strands in adjacent turns of a superconductor magnetic field coil. Notably, both mechanisms may act in parallel. Thus, during a quench, an assembly, for example a superconductor magnetic field coil, may show improved quench behavior. As explained herein, the resistance, for example of the metallic stabilizer material, may be adjusted in a way to further optimize the process and for example allow for uniform quench behavior of a plurality of assemblies, for example of a plurality of superconductor magnetic field coils in a stellarator. In some examples, a heating of the assembly during a quench event is more uniform due to both fast normal zone propagation along the plurality of strands and inductive current transfer due to inductive coupling. This may lead to improved quench behavior compared with assemblies in which one or both of these mechanisms are not present.

The insulation material may help control undesired current paths and may enhance the stability of the coil. The series connections may ensure efficient electrical connectivity between strands, facilitating controlled current paths during normal operation and quench events contributing to the overall performance and reliability of the superconductor magnetic field coil. Additionally, the series connections may simplify manufacturing, for example if the length of strands that can be achieved is limited and/or if manufacturing of an arrangement is simplified by using shorter strands.

In the following, definitions are provided and further examples are described.

A "strand" may comprise at least one wire of superconducting cable, for example a single high temperature superconductor tape, for example at least one stack of high temperature superconductor tape.

Superconductor material may comprise high temperature superconductor material, optionally a single high temperature superconductor tape, optionally at least one stack of high temperature superconductor tape.

Ohmic heating material may comprise at least one layer of ohmic heating material as described herein. Ohmic heating material may be bulk ohmic heating material. In the following, first, second, third etc. ohmic heating materials are disclosed. Those ohmic heating materials may be identical or different materials. This applies for the other materials disclosed herein, mutatis mutandis.

For example, as described in Example 11 in Annex B, the ohmic heating material may comprise at least one of the following materials: silicon carbide, semi-metals, semiconductors, anodised aluminium, matrix composites. However, other materials, for example as disclosed in the Annexes, are possible.

Ohmic heating material may have a surface resistivity between 10⁻⁷ Ohm·m² and 1 Ohm·m², optionally between 10⁻⁻⁶ Ohm·m² and 10⁻¹ Ohm·m², optionally between 10⁻⁵ Ohm·m² and 10⁻² Ohm·m², optionally between 10⁻⁴ Ohm·m² and 10⁻³ Ohm·m², optionally between 2 · 10⁻⁴ Ohm.m² and 5 · 10⁻⁴ Ohm·m², optionally of approximately 3 · 10⁻⁴ Ohm·m²; and/or.

In some embodiments, the ohmic heating material may have a surface resistivity between 10⁻⁷Ohm·m² and 3·10⁻⁴ Ohm · m², optionally between 5 ·10⁻⁷ Ohm·m² and 1.5 · 10⁻⁴ Ohm·m², optionally between 1 · 10⁻⁶ Ohm·m² and 7.5 · 10⁻⁵ Ohm·m², optionally between 5 · 10⁻⁶ Ohm·m² and 3 · 10⁻⁵ Ohm·m², optionally between 10⁻⁵ Ohm.m² and 1.5 · 10⁻⁵ Ohm·m², optionally between 3 · 10⁻⁵ Ohm·m² and 1 · 10⁻⁵ Ohm·m²

In some embodiments, the ohmic heating material may have a surface resistivity between 3 · 10⁻⁴Ohm·m² and 1 Ohm·m², optionally between 1 · 10⁻³ Ohm·m² and 3 · 10⁻¹ Ohm·m², optionally between 3 · 10⁻³ Ohm·m² and 1 · 10⁻¹ Ohm·m², optionally between 1 · 10⁻² Ohm·m² and 3 · 10⁻² Ohm·m², optionally between 3 · 10⁻² Ohm·m² and 1 · 10⁻¹ Ohm·m², optionally between 1 · 10⁻¹ Ohm·m² and 3 · 10⁻¹ Ohm·m².

The first, second, third etc. ohmic heating material may have similar or identical values of surface resistivity. In other examples, the first ohmic heating material may have a different value or value-range, for example one of the values or value ranges disclosed herein from the second ohmic heating material etc.

However, other ranges are possible as well. Further alternatives and examples are provided in the examples in the appendix.

The selection of specific resistivity ranges affects the normal zone propagation velocity and heat dissipation characteristics during quench events.

In some examples, the metallic stabilizer materials disclosed herein, for example the first metallic stabilizer material, and/or the ohmic heating material disclosed herein, for example the first ohmic heating material, may be identical materials. In other words, in some embodiments the metallic stabilizer material may not be present and be entirely made from ohmic heating material. In other embodiments, the ohmic heating material and the metallic stabilizer material may be embodied by a single material which has a gradient, for example a gradient of the conductivity that may provide different resistivity properties at different locations in the arrangement.

The metallic stabilizer materials may comprise copper, aluminum, or other conductive metals that provide thermal and electrical stabilization for the superconductor material. Further alternatives and examples are provided in the examples in the Annex.

The insulation material may partially enclose the plurality of strands. In some examples, the insulation material may entirely enclose the plurality of strands. In some examples, the insulation material may entirely enclose the plurality of strands along the length of the plurality of strands. In some examples, for example in case a plurality of strands is arranged in at least one turn as described herein, the insulation material may partially enclose the plurality of strands by only or predominantly being present on one side of the at least one turn. This may form an insulation of the plurality of strands between adjacent turns of the at least one turn. However, in some cases no double isolation layers of adjacent turns are present. In other words, in some cases one isolation layer is shared between adjacent turns.

A strand may have two ends, a first end of the strand and a second end of the strand. In the figures below, a first end of a strand may be denoted using an "b", for example "Ab" as for a first end of strand "A". The second end may be denoted by "e", for example "Ae" as the second end of strand "A". In some examples, the first end and the second end may be used interchangeably. In some examples, the first end may be the end towards the outer side of a turn of the strand, and the second end may be the end towards the inner side of a turn of a strand. In some examples, the first end may be the end of the strand on the outside of a coil, the second end may be the end on the inside of a coil.

The term "strand arrangement" may refer to the configuration of multiple strands within a superconductor coil. "Superconductor material" may refer to materials that exhibit zero electrical resistance below a certain temperature. "Ohmic heating material" may refer to a material that produces heat when electrical current passes through it, due to its resistance. "Insulation material" may refer to a material that electrically insulates strands from their surroundings. The insulation material may define or demarcate or enclose a superconductor cable as described herein comprising the plurality of strands, the ohmic heating material and optionally the metallic stabilizer material for example described above or further alternatives described below.

For the various examples, the plurality of strands of superconductor material, the ohmic heating material, the insulation material and/or the metallic stabilizer material may be provided as one or more superconductor cables according to the examples provided below, for example in the Annexes.

For example, the first plurality of strands may form a superconductor cable, for example a superconductor cable for a superconductor cable assembly as disclosed herein, for example in Annex A, B, and/or C.

"Electrical series connection" may refer to a connection in which electrical current flows sequentially through multiple components. Implementations are disclosed below. The electrical series connection may be a general electrical series connection. It may be embodied by any of the electrical series connections described below, for example the first electrical series connection, the second electrical series connection etc.

### Further examples

In one example, the strand arrangement further comprises a third strand of the first plurality of strands, wherein the first ohmic heating material is arranged between the first strand, the second strand, and the third strand of the first plurality of strands, and a second electrical series connection connecting a second end of the second strand of the first plurality of strands with a first end of the third strand of the first plurality of strands.

In the following, further examples are described, sometimes with reference to pancake coils or double pancake coils or arrangements. Such arrangements may be in particular beneficial for non-planar magnetic field coils. Pancake coils may be understood to be coils which comprise turns of strands with increasing radius in a plane, thus forming a spiral path in a plane, optionally a plane of the pancake. A double pancake coil may have two pancakes in different planes. The planes may be strictly planar in a cartesian sense, but may also have a more complex topology, for example planar but also have more complex topology, for example be a curved plane etc.

Some of the examples below are explained with reference to such pancake-like structures. In further examples, non-pancake structures are used, for example to coils which have turns with an essentially fixed radius and where turns are stacked on each other, for example forming a helix, for example in solenoids. Notably, in stellarators different types of coils may be combined, for example solenoid-like coils in planar coils and pancake-structure based coils in non-planar coils.

In one example, the strand arrangement may further comprise a first double pancake coil. The strand arrangement may further comprise a second plurality of strands composed of superconductor material. This second plurality of strands may consist of a first strand and a second strand. Additionally, a second ohmic heating material may be arranged between the first strand and the second strand of the second plurality of strands. Furthermore, a second insulation material may at least partially enclose the second plurality of strands. The electrical series connection in this configuration may be a third electrical series connection, and the further strand may be the second end of the first strand of the second plurality of strands.

The strand arrangement may comprise: a fourth electrical series connection connecting a second end of the second strand of the first plurality of strands with a second end of the second strand of the second plurality of strands.

The strand arrangement may comprise: a fifth electrical series connection connecting a first end of the second strand of the first plurality of strands with a first end of the first strand of the second plurality of strands.

In one example, the strand arrangement may optionally comprise a second double pancake coil. The strand arrangement may further include a third plurality of strands of superconductor material. This third plurality may comprise a first strand and a second strand, with a third ohmic heating material arranged between these strands. A third insulation material may at least partially enclose this third plurality of strands.

Additionally, the strand arrangement may include a fourth plurality of strands of superconductor material, comprising a first strand and a second strand. A fourth ohmic heating material may be arranged between these strands of the fourth plurality, with a fourth insulation material at least partially enclosing this fourth plurality of strands.

The strand arrangement may further include at least one of the following electrical series connections:
- A sixth electrical series connection may connect a second end of the first strand of the third plurality with a second end of the first strand of the fourth plurality of strands;
- A seventh electrical series connection may connect a second end of the second strand of the third plurality with a second end of the second strand of the fourth plurality;
- An eighth electrical series connection may connect a first end of the second strand of the third plurality with a first end of the first strand of the fourth plurality; and/or
- A ninth electrical series connection may connect a first end of the second strand of the second plurality with a first end of the first strand of the third plurality.

In one example, the strand arrangement may optionally comprise a bus-bar arrangement. The strand arrangement may further include one or more electrical series connections, such as:
A tenth electrical series connection may connect the second end of the first strand of the first plurality of strands with a second end of the second strand of the first plurality of strands; and/or
An eleventh electrical series connection may connect a first end of the second strand of the first plurality of strands with a first end of the third strand of the first plurality of strands.

Such an arrangement, for example a bus-bar arrangement may have improved quench properties and may prevent arcing in case of a quench.

While the electrical series connections are described with numbering for ease of reference (first, second, third... etc. electrical series connection), different numbering or no numbering may be used. These series connections, regardless of their designation, may be identical in some examples, for example as joints, strands, cables etc. as described herein. In other examples, the different electrical series connections differ, for example may be embodied by different types of joints, strands, cables etc. For example, in coil designs, the electrical connections at the outside of a coil may be different from the designs in the inside of the coils.

In another example, the strand arrangement may further comprise at least one of the following:
A first metallic stabilizer material that may extend along the first plurality of strands and, optionally, the first ohmic heating material may be arranged between the first plurality of strands and the first metallic stabilizer material;
A second metallic stabilizer material that may extend along the second plurality of strands and, optionally, the second ohmic heating material may be arranged between the second plurality of strands and the second metallic stabilizer material;
A third metallic stabilizer material that may extend along the third plurality of strands and, optionally, the third ohmic heating material may be arranged between the third plurality of strands and the third metallic stabilizer material;
A fourth metallic stabilizer material that may extend along the fourth plurality of strands and, optionally, the fourth ohmic heating material may be arranged between the fourth plurality of strands and the fourth metallic stabilizer material.

The inclusion of metallic stabilizer materials may allow to carry the current in regions in which all strands of the plurality of strands have lost their superconductor properties. In some examples, the metallic stabilizer materials may lead to a minimum power dissipation due to ohmic heating in such cases. Further, the inclusion of metallic stabilizer materials may enhance the mechanical stability and durability of the strand arrangement and heat dissipation, in particular during quench events. The arrangement of ohmic heating materials can facilitate effective heat dissipation, preventing overheating and ensuring reliable performance, in particular during quench events. The tailored approach to stabilizing different sections of the strand arrangement may allow for improved management of stress and thermal load. Extending along the strands, the metallic stabilizer materials can contribute to maintaining optimal alignment and spacing, which is crucial for electrical performance. The optional arrangement of ohmic heating materials provides flexibility in design, allowing for customization based on specific operational requirements. Such configurations may provide increased normal zone propagation velocity along the length of the strands, which may improve quench protection.

In one example, the strand arrangement further comprises a second metallic stabilizer electrically insulated from the plurality of strands, optionally insulated by the insulation material, wherein the second metallic stabilizer is optionally arranged as a secondary winding for an induction created by a change of current in the plurality of strands and, optionally, provides a structural support for the superconductor magnetic field coil.

In a further example, the strand arrangement may have at least one of the first plurality of strands, the second plurality of strands, the third plurality of strands, and/or the fourth plurality of strands arranged in at least one turn. When the strand arrangement includes a plurality of turns, the number of turns may optionally comprise one of the following configurations: at least 3 turns, at least 5 turns, at least 10 turns, at least 20 turns, at least 50 turns, at least 100 turns and/or at most 1000 turns, and/or at most 2000 turns and/or at most 5000 turns.

The technical effect of these features may include improved structural integrity and organization of the strands, which can lead to enhanced performance of the superconductor magnetic field coil. The arrangement in turns can also facilitate better management of the magnetic field, potentially resulting in more efficient operation of the coil. Additionally, specifying the number of turns can provide a guideline for optimizing the design, ensuring that the strand arrangement meets the desired specifications for different applications. This can lead to more effective utilization of the superconductor material and the overall strand arrangement. The inclusion of these features can also contribute to the reliability and durability of the strand arrangement, as the organized structure may reduce the risk of damage or malfunction. Overall, the implementation adds valuable details to the strand arrangement, offering potential benefits in terms of performance, adaptability, and reliability.

In yet another example, the strand arrangement may include at least one strand of the first plurality of strands, the second plurality of strands, the third plurality of strands, and/or the fourth plurality of strands that may be divided into a plurality of strand segments. Optionally, these strand segments may be connected with each other in a series connection to form the strand.

Additionally, when the strand arrangement includes at least one turn, the strand segments may be connected by joints and/or series connections between turns of the at least one turn.

The technical effect of these features may include enhanced flexibility in the design and assembly of the strand arrangement, allowing for more complex geometries and configurations that can be tailored to specific application requirements. The division of strands into segments can facilitate easier handling and installation, as well as potentially improve the mechanical robustness of the arrangement by distributing stress more evenly across the segments. The use of joints and series connections between turns can ensure reliable electrical performance by providing secure connections that maintain the integrity of the electrical path, which is essential for the efficient operation of superconducting coils. Furthermore, these features can contribute to improved thermal management within the strand arrangement, as the segmentation and connections may allow for more effective dissipation of heat generated during operation and/or quench events.

In another example, the strand arrangement may include at least one of the first, second, third, fourth, fifth, sixth, seventh, eighth, ninth, tenth, and/or eleventh electrical series connection with specific resistance characteristics. These electrical series connections may:
Have a first resistance below 1 µOhm, possibly below 50 nOhms, or even below 10 nOhms; and/or
Have a first resistance value that may be at least 10 times lower, optionally 100 times lower, or optionally at least 1,000 times lower, than the resistance between two strands of the respective plurality of strands.

The specified low resistance values in the electrical series connections may enhance the electrical performance and efficiency of the strand arrangement. The reduced resistance can minimize energy loss and heat generation, contributing to the stability and reliability of the arrangement. Additionally, the low resistance connections may facilitate better control over the electrical properties, leading to more precise and consistent operation. This can improve the effectiveness of magnetic field generation and maintenance in superconductor magnetic field coils, making them more suitable for various applications. The low relative resistance may ensure that the current flows along the series connection instead of passing between strands of the same plurality of strands.

While described for a numbered electrical series connection (first, second... electrical series connection), the above may apply in general for any electrical series connection described herein.

In a further example, at least one of the first, second, third, and/or fourth metallic stabilizer material may be configured in at least one of the following arrangements:
The metallic stabilizer material may be arranged along a coil, inductively coupled to its corresponding plurality of strands;
The metallic stabilizer material may be arranged to form a loop between a first end of the coil and a second end of the coil;
The metallic stabilizer material may be arranged in a closed loop within a single turn of the at least one turn;
A "closed loop" may be a continuous and/or uninterrupted path of material, for example of the metallic stabilizer material. A "closed loop" can form a complete circuit, wherein the path begins and ends at the same point without any electrical discontinuities. A "closed loop" may act as a primary and/or secondary winding for an induction coil.
The metallic stabilizer material may be connected in series between the at least one turn and a second turn, wherein the second turn may optionally be a turn of at least one turn of the second plurality of strands;
The metallic stabilizer material may form a loop over the at least one turn and the second turn.

The arrangement of the metallic stabilizer material along a coil and its inductive coupling to the corresponding plurality of strands may enhance the inductive properties and stability of the coil, in particular during quench events. Forming a loop between a first end of the coil and a second end of the coil can provide a continuous path for electrical current and improve the efficiency of the coil. Arranging the metallic stabilizer material in a closed loop within a single turn of the at least one turn may contribute to uniform current distribution and reduce hotspots. Connecting the metallic stabilizer material in series between the at least one turn and a second turn can facilitate current transfer between different coil sections and improve performance. Forming a loop over the at least one turn and the second turn may provide additional structural support and enhance mechanical stability.

The above options may effectively allow to short-circuit the coil or single turns during a quench as the current may be no longer carried by the superconductor strands and instead may migrate to the metallic stabilizer where it may be short circuited or inductively dissipated. This may improve quench properties of the arrangement.

In an additional example, the strand arrangement may include at least one turn comprising a plurality of turns. At least one of the first, second, third, and/or fourth metallic stabilizer material may be arranged in at least one turn of the plurality of turns as a secondary winding. This arrangement may function as a secondary winding for an induction created by a change of current in the respective plurality of strands in another turn of the plurality of turns.

The arrangement of metallic stabilizer materials as secondary windings may enhance inductive coupling between different turns, which may improve quench behavior and/or energy dissipation during off-normal events in the arrangement.

In another example, the strand arrangement may have at least one of the first, the second, the third and/or the fourth plurality of strands comprising one of the following configurations:
2 strands, 3 strands, 4 strands, 5 strands, 6 strands, 7 strands, 8 strands, 9 strands, 10 strands, 11 strands, 12 strands, 13 strands, 14 strands, 15 strands, 16 strands, 17 strands, 18 strands, 19 strands, 20 strands, 21 strands, 22 strands, 23 strands, 24 strands, 25 strands, 26 strands, 27 strands, 28 strands, 29 strands, 30 strands, 31 strands, 32 strands, 33 strands, 34 strands, 35 strands, 36 strands, 37 strands, 38 strands, 39 strands, 40 strands;
between 2 and 4 strands; between 4 and 6 strands; Between 6 and 8 strands; and/or between 8 and 10 strands.

If an odd number of strands are used, for example 3 strands, this may have the advantage that with a series connection as described herein between the strands the strand arrangement may be used as a busbar system, e.g. by zig-zacking of current back and forth. The number of strands may allow to optimize the heat dissipation and the current profiles of the arrangement and the migration of current during quench events, for example through the ohmic heating material and/or the metallic stabilizer material.

In an example where the strand arrangement may be used for a superconductor magnetic field coil, the strand arrangement may include at least one turn comprising a plurality of strand segments. In such an arrangement:
The at least one turn may comprise a first turn and a second turn, wherein the plurality of strand segments within the first turn may be connected in series with a plurality of strand segments of the second turn, and/or
The plurality of strand segments of the at least one turn may be connected in series within the at least one turn.

These arrangements may provide a superconductor magnetic field coil with improved quench behavior, for example for stellarator applications as described herein.

The strand arrangement may utilize superconductor material that comprises a high temperature superconductor material. This superconductor material may optionally be in the form of a high temperature superconductor tape, which may optionally be a rare earth barium copper oxide, ReBCO, tape.

The inclusion of high temperature superconductor material, such as ReBCO tape, may enhance the strand arrangement's ability to operate at higher temperatures, potentially reducing cooling costs and complexity. It can also improve critical current densities, which may increase the efficiency and effectiveness of the strand arrangement in applications like superconductor magnetic field coils. Furthermore, the use of ReBCO tape may provide better mechanical properties, offering improved flexibility and durability, and may facilitate easier manufacturing processes and integration, for example in fusion application.

In one example, a superconductor magnetic field coil may be provided. The superconductor magnetic field coil may be comprising a strand arrangement according to any one of the previous claims.

Additionally, or alternatively, the superconductor magnetic field coil may include at least one insulated plurality of superconductor strands arranged in at least one turn. Each plurality of the superconductor strands may be electrically connected in series by low-resistance inter-strand joints. This configuration may allow the insulated plurality of superconductor strands to behave as a non-insulated (NI) coil with a number of turns corresponding to the number of strands connected in series.

Additionally, or alternatively, the superconductor magnetic field coil may include at least one ohmic heating material arranged between the insulated plurality of superconductor strands and at least one metallic stabilizer material. The ohmic heating material and the metallic stabilizer material may provide an ohmic heating path along the insulated plurality of superconductor strands.

The term "superconductor magnetic field coil" may refer to a coil designed to generate a magnetic field using superconducting materials, for example for fusion applications, for example for a stellarator.

"Insulated plurality of superconductor strands" may refer to multiple strands of superconducting material that are electrically insulated from each other and/or may be one of the first, second, third etc. plurality of superconductor strands, optionally with first, second, third etc. insulation material as described herein.

The advantages of this configuration include the ability of the coil to behave like a non-insulated coil despite the insulation of individual strands, which can enhance the robustness and current density of the coil. The inclusion of ohmic heating material and metallic stabilizer material may ensure efficient heat distribution and stabilization during regular operation and/or during quench events, which may be crucial for maintaining superconducting properties and/or preventing damage during quenching events.

In one example, the superconductor magnetic field coil may include at least one metallic stabilizer material comprising at least one of the following configurations:
The metallic stabilizer material may form connections between a first and a second end of the superconductor magnetic field coil;
The metallic stabilizer material may form at least one closed loop within a single turn of the at least one turn;
The metallic stabilizer material may comprise at least one set of metallic stabilizer material, with each set arranged with one of the insulated plurality of superconductor strands to form at least one resistive coil inductively coupled to the insulated plurality of superconductor strands;
The metallic stabilizer material may form connections between a first set or all of the set of metallic stabilizer material and a second set or all of the metallic stabilizer material.

The connections formed by the metallic stabilizer material may reduce electrical resistance and improve current flow, in particular during quench events. The closed loop within a single turn can enhance structural integrity and stability. The arrangement of metallic stabilizer material with superconductor strands to form resistive coils can improve the coil's response to magnetic field changes, for example during quench events. Connections between different sets of metallic stabilizer material may distribute electrical and thermal loads more evenly, potentially reducing hotspots and improving durability, for example during quench events.

In another example, the strand arrangement and/or superconductor magnetic field coil may include at least one of the ohmic heating material, the second ohmic heating material, the third ohmic heating material, the fourth ohmic heating material, and/or additional ohmic heating material that may have a surface resistivity between 10⁻⁷ Ohm·m² and 1 Ohm·m².

However, as described in the Annexes, different values of the surface resistivity are possible. Also, as described in the various examples in the Annexes, different materials, layers or combinations of layers and materials as set out in the examples of the Annexes can be used for the ohmic heating material.

The same applies for the other materials mentioned herein. For example various metallic stabilizer materials as described in the Annexes or other materials or combinations may be used.

In a further example, a stellarator may be provided. This stellarator may comprise at least one strand arrangement and/or at least one superconductor magnetic field coil as described in any of the previous examples.

Such a stellarator may have improved quench properties and/or reduced capital costs due to reduced material costs due to potentially advantageous properties of the strand arrangements and/or superconductor magnetic field coils described herein.

### BRIEF DESCRIPTION OF THE DRAWINGS

One or more embodiments will now be described by way of example only with reference to the accompanying drawings in which the Figures show the following:
Figure 1 shows an embodiment of a stellarator with superconductor magnetic field coils.
Figure 2 shows an embodiment of a strand arrangement with three strands forming a turn.
Figure 3 shows an embodiment of a strand arrangement with superconductor strands enclosed by insulation material, featuring ohmic heating material and metallic stabilizer material.
Figure 4 shows an embodiment of a strand arrangement with multiple turns.
Figure 5a shows an embodiment of a strand arrangement with multiple turns and series connections.
Figure 5b shows an embodiment of a strand arrangement with electrical series connections and ohmic heating material.
Figure 6c shows an embodiment of a strand arrangement with multiple turns.

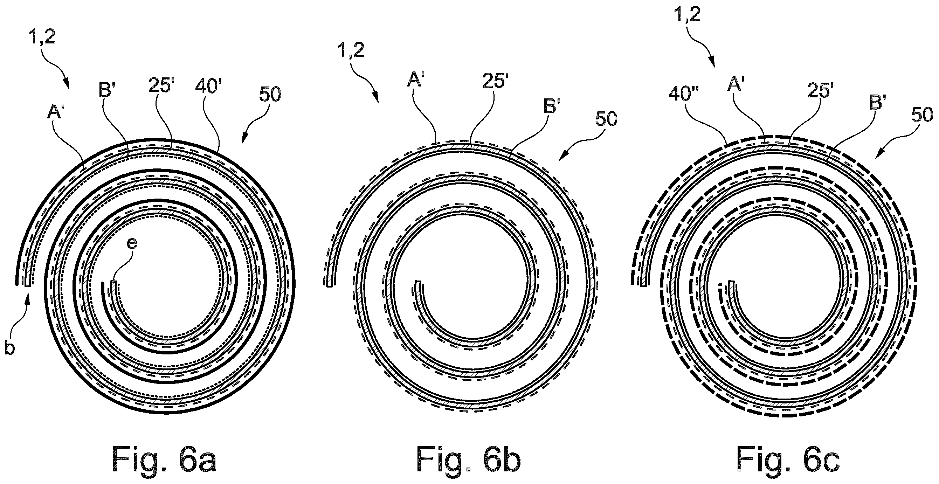

Figure 6a shows an embodiment of a strand arrangement with multiple turns and various materials.
Figure 6b shows an embodiment of a strand arrangement with turns.

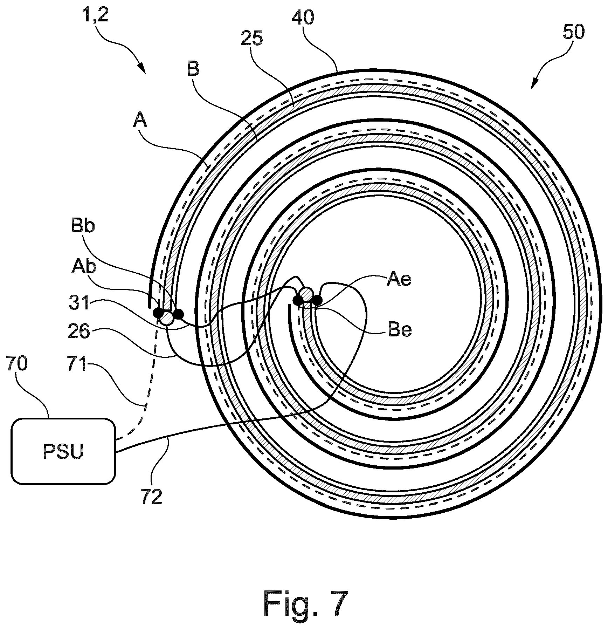

Figure 7 shows an embodiment of a strand arrangement with a power supply unit connected to a coil consisting of multiple turns, illustrating the electrical series connections and insulation materials.

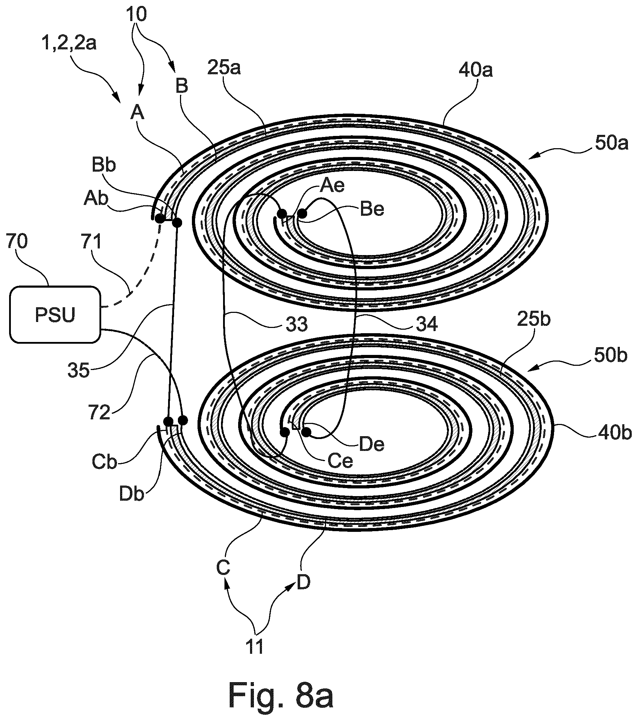

Figure 8a shows an embodiment of a strand arrangement with multiple electrical series connections and turns.

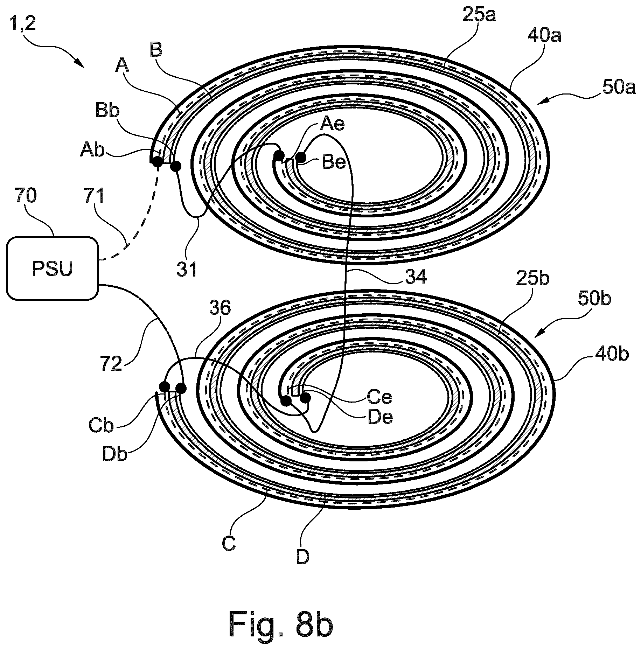

Figure 8b shows an illustrative diagram of a strand arrangement with multiple turns and electrical series connections, including a power supply unit.

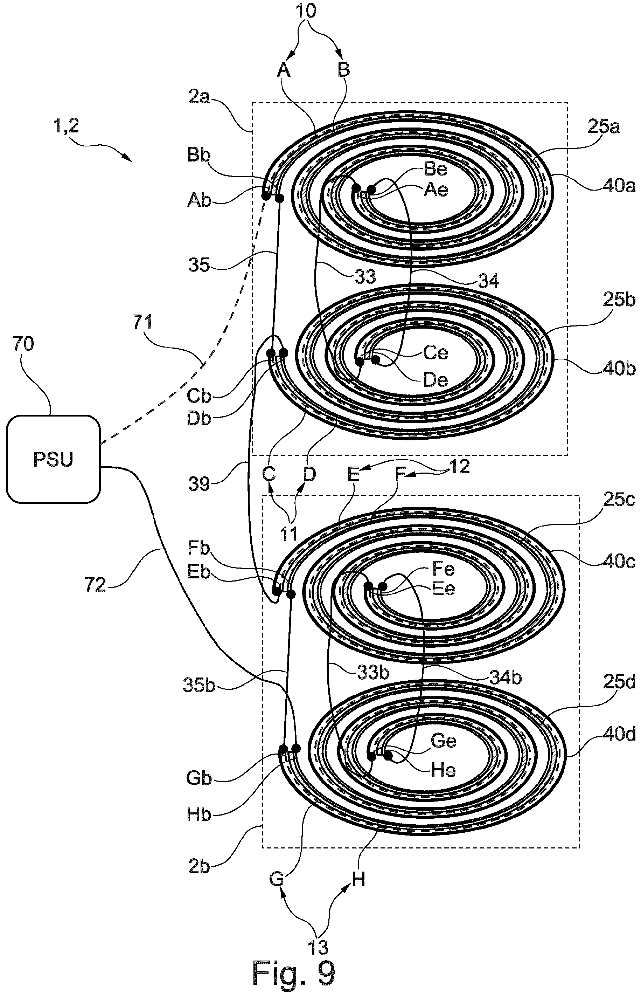

Figure 9 shows an embodiment of a strand arrangement with multiple superconductor magnetic field coils connected to a power supply unit.

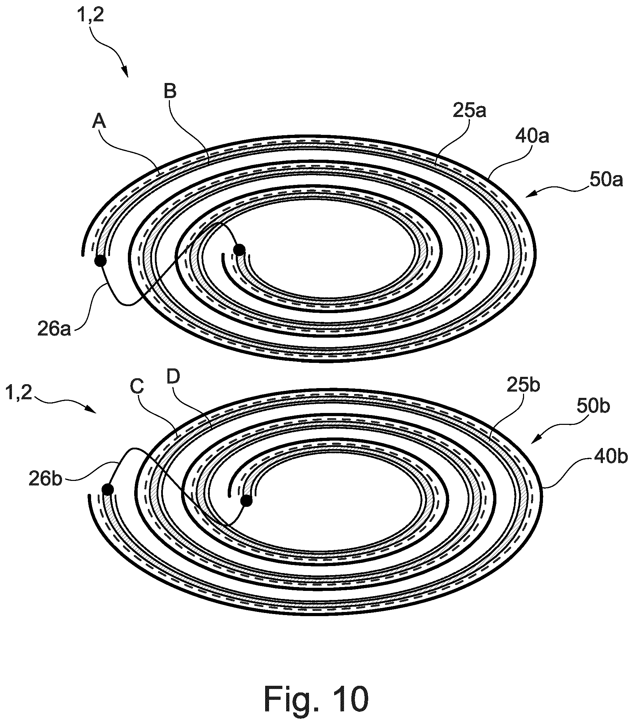

Figure 10 shows an embodiment of a strand arrangement with multiple turns and connections, illustrating a possible configuration of metallic stabilizer material.

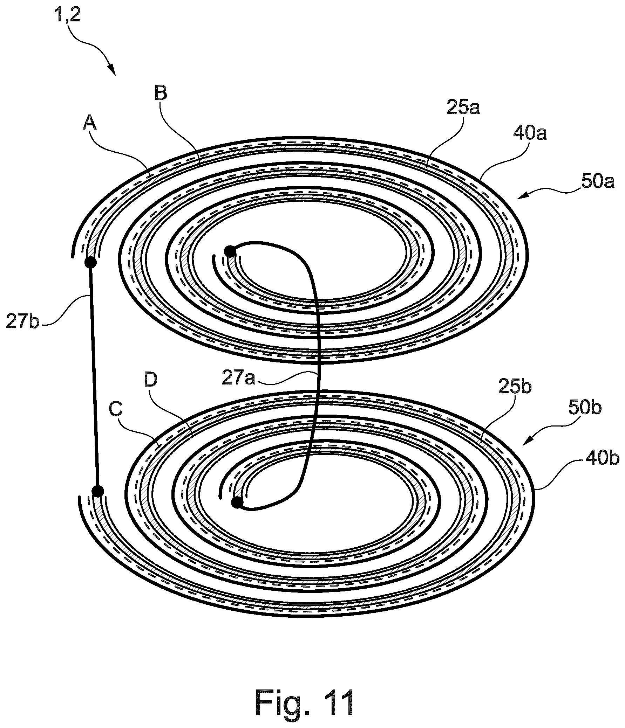

Figure 11 shows an embodiment of a strand arrangement with two double pancake coils, illustrating a possible configuration of metallic stabilizer material.

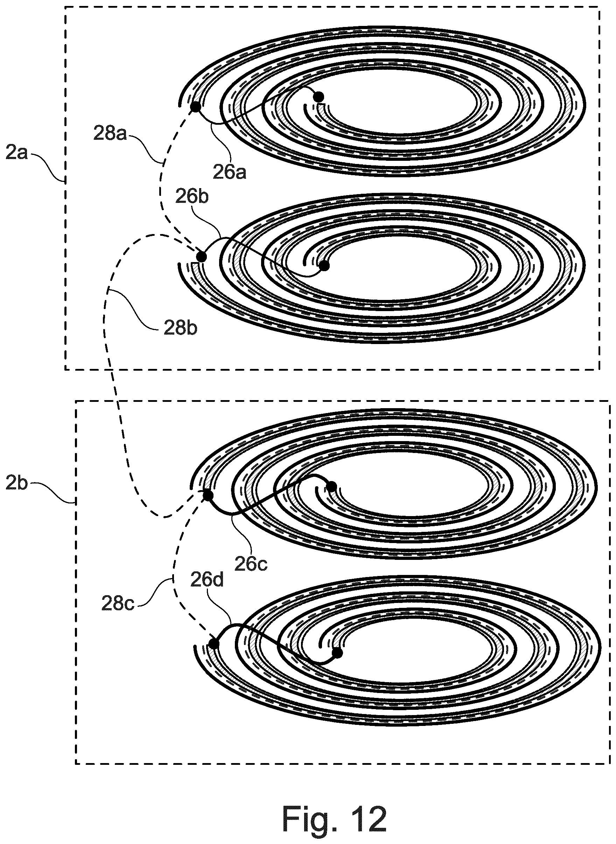

Figure 12 shows an illustrative diagram of interconnected double pancake coils, illustrating a possible configuration of metallic stabilizer material.

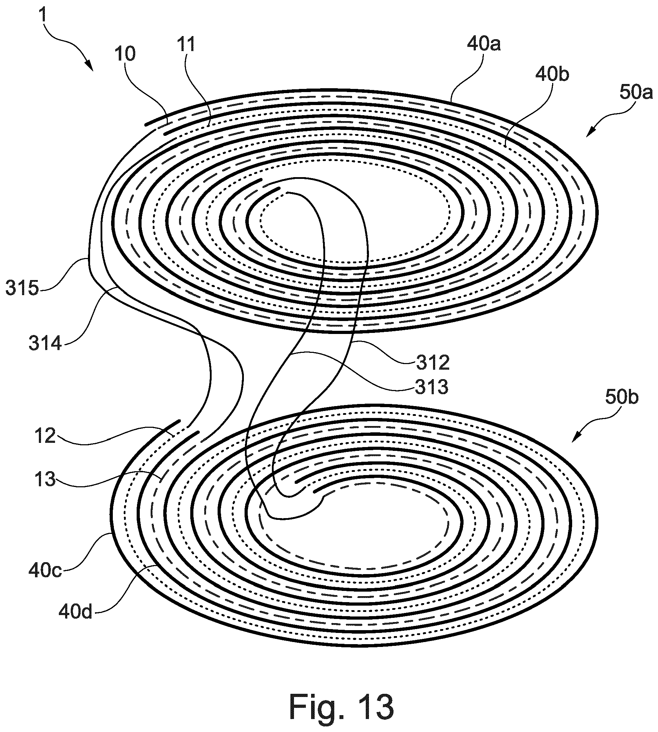

Fig. 13 shows a double pancake coil according to an example.

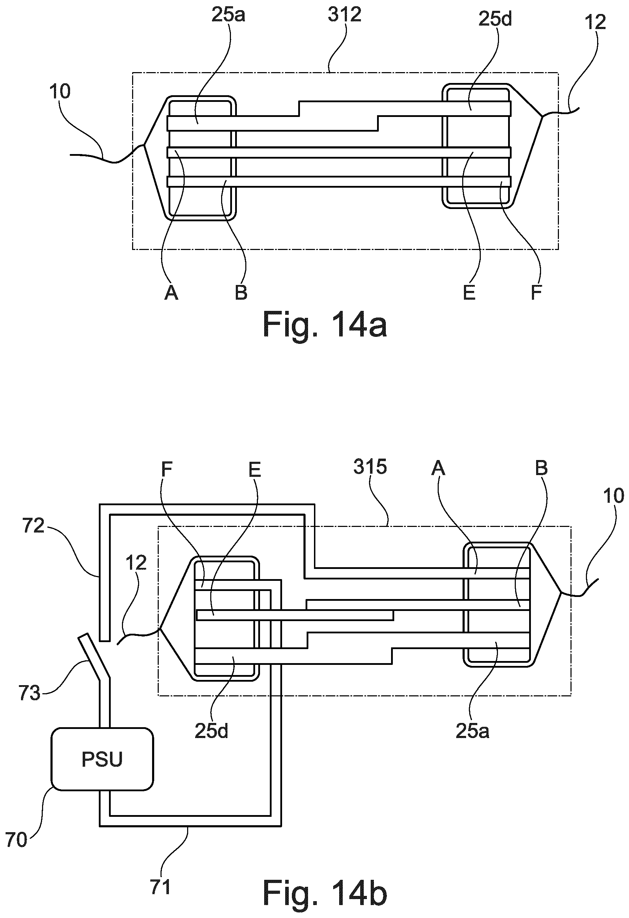

Fig. 14a and Fig. 14b show examples for series connections between pluralities of strands.

### DETAILED DESCRIPTION OF THE DRAWINGS

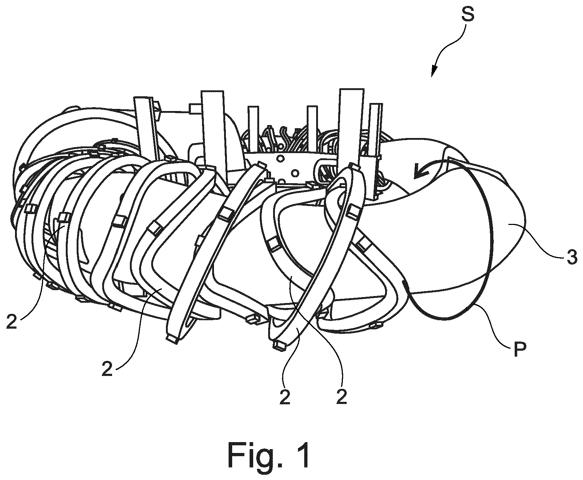

Figure 1 shows a stellarator configuration used for plasma confinement. The central component is the confined plasma 3, which is surrounded by a series of coils 2. These coils are arranged to create a magnetic field that confines the plasma in a stable configuration. The coils are oriented in both the poloidal direction P and the toroidal direction S, ensuring the plasma remains confined within the designated space. The coils are supported by a structure that maintains their precise positioning, crucial for effective plasma confinement.

The coils 2 or bus bar systems that provide current to coils 2 (not shown in fig. 1) as well as other components may comprise examples as disclosed herein. This will be further explained with reference to the other figures.

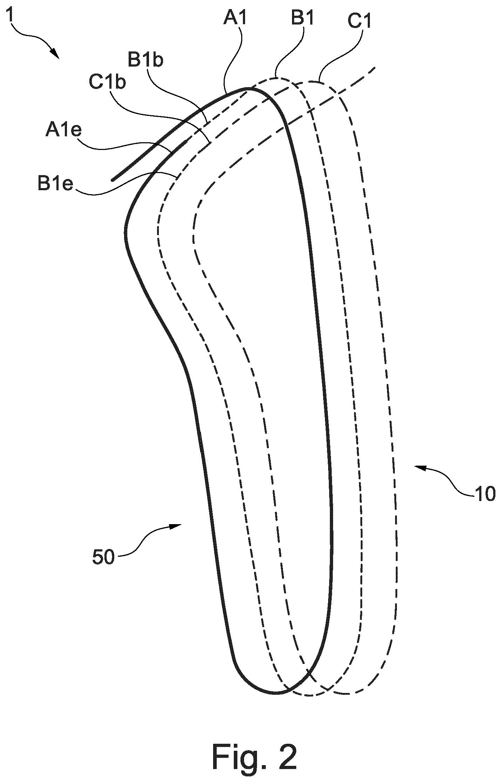

Figure 2 shows a strand arrangement 1 comprising a first plurality of strands 10 of superconductor material. In the example of Fig. 2, first plurality of strands 10 comprises strands A1, B1, and C1. However, as described other number of strands are possible as well. The first strand A1 has a first end and a second end A1e. The second strand B1 is positioned adjacent to the first strand A1, and the third strand C1 is positioned adjacent to the second strand B1. The strands are arranged in such a manner that they form turns 50, which are part of the strand arrangement 1.

The figure illustrates the electrical series connection between the strands. Specifically, the second end A1e of the first strand A1 is connected to the first end B1b of the second strand B1. This connection ensures that the strands are electrically connected in series, facilitating the flow of current through the strand arrangement 1. Additionally, the first end B1e of the second strand B1 is connected to the first end C1b of the third strand C1, further extending the series connection within the strand arrangement 1.

The strands may at least be partially enclosed by an insulation material, which is not explicitly shown in Figure 2 but may be part of the strand arrangement 1. This insulation material may serve to electrically isolate the strands from each other during turns such as turn 50 of Fig. 2, preventing short circuits and ensuring the proper functioning of the superconductor magnetic field coil.

The at least one turn 50 formed by the strands may allow forming of a superconductor magnetic field coil, for example for a stellarator. Fig. 2 shows a single turn 50 of the assembly. The turns may create a magnetic field when current flows through the strands. In the connection scheme shown in Fig. 2, the single turn 50 of the first plurality of strands is equivalent to three turns of a single current carrying wire due to the series connections of the strands. Thus, in some examples the amount of turns of a superconducting cable comprising a plurality of strands according to the examples disclosed herein may be reduced compared to a conventional cable. To achieve a given magnetic field, the product of current and turns of that current must be the same. Thus, the arrangements described herein may allow alternative ways to achieve the current and turns of current, for example by reducing the amount of turns of a cable required to achieve the same amount of turns of current due to series connection of the strands in the cable.

Ohmic heating material, not shown in Fig. 2, may be arranged between the strands. This material is responsible for providing an ohmic heating path along and between the strands, for example during a quench of a single or multiple strands.

The strand arrangement 1 shown in Figure 2 may be part of a superconductor magnetic field coil, which can be used in various applications requiring strong and stable magnetic fields, for example in the stellarator of fig. 1. The series connections between the strands, the insulation material, and the ohmic heating material may individually and/or in combination contribute to the efficient and reliable operation of the coil.

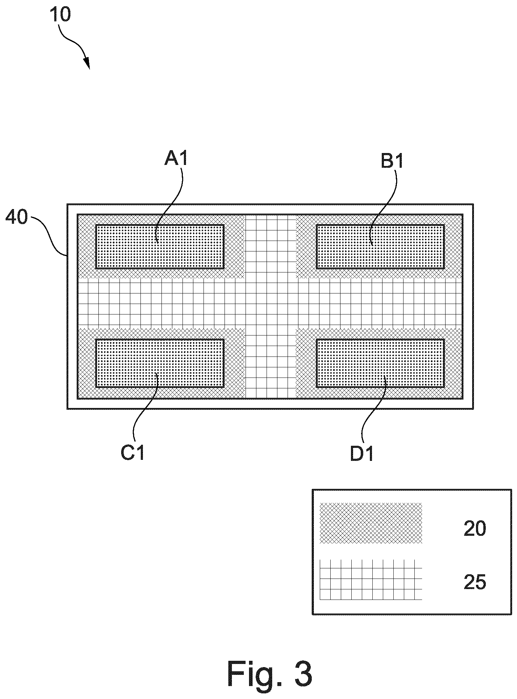

Figure 3 shows a cross-sectional view of a strand arrangement 10, which is optionally intended for use in a superconductor magnetic field coil. The figure illustrates the detailed internal configuration of the strand arrangement, highlighting the various components and their spatial relationships.

The strand arrangement 10 comprises multiple strands of superconductor material, specifically identified as strands A1, B1, C1, and D1. Each of these strands is enclosed by an insulation material 40, which serves to electrically isolate the strands from external components and from adjacent windings of the strands. The insulation material 40 is depicted as surrounding the entire cross-section of the strand arrangement, ensuring comprehensive insulation coverage.

Between the strands A1, B1, C1, and D1, there is an ohmic heating material 20. This material is strategically positioned to provide controlled heating within the strand arrangement during quench events. The ohmic heating material 20 is shown as a shaded region in the figure, indicating its placement between the strands. This material is essential for managing the thermal properties of the superconductor strands, facilitating the transition between superconducting and normal states as required.

Additionally, the figure includes a metallic stabilizer material 25, which is represented by a grid-like pattern. The metallic stabilizer material 25 may extend along the strands and may be positioned adjacent to the ohmic heating material 20. This stabilizer material may enhance the mechanical stability and electrical performance of the strand arrangement, for example the quench behavior, for example by providing a possibility for heat dissipation during a quench event and/or for redistribution of current between the plurality of strands. For example, the metallic stabilizer material may carry the current "ejected" from the quenched strands. Further, the metallic stabilizer material may have a heat capacity sufficient to allow "dumping" of at least parts of the energy of the current during a quench. Further, as described elsewhere herein, the metallic stabilizer material may act as an inductive current loop or coil during fast field changes during quench events. In addition, or alternatively, when a quench forms in one region the strands may become non-superconducting, leading to inductive effects that may be picked up by strands in a different region which are still superconducting and/or the metallic stabilizer material, thereby distributing the current along the length of the strands and/or strand arrangement.

The cross-sectional view in Figure 3 shows how the strands, insulation material, ohmic heating material, and metallic stabilizer material may be integrated within the strand arrangement. Such an arrangement may form a cable. In some examples, such a cable is used in the examples disclosed herein. In other examples, instead of the cable shown in Fig. 3 other superconductor cables, such as disclosed in the Annexes, are used in addition or alternatively.

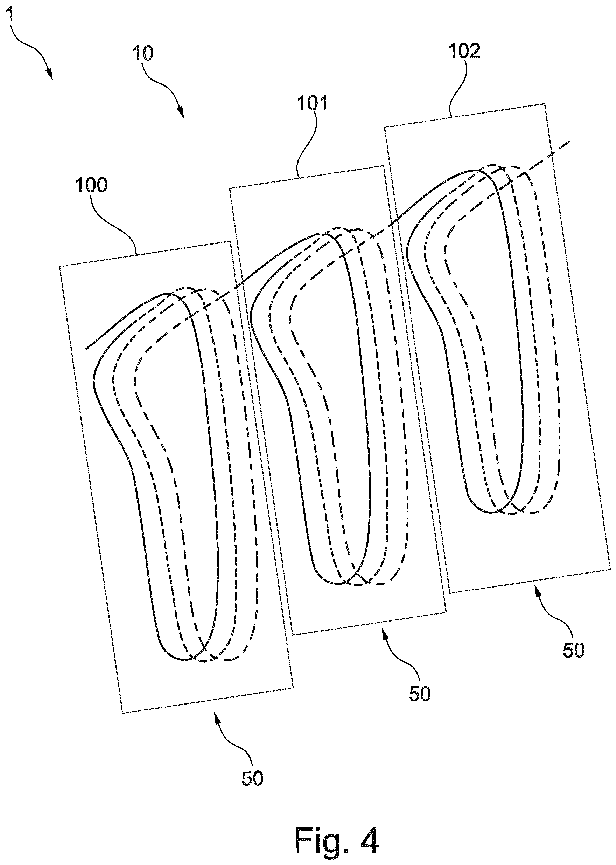

Fig. 4 shows a further example for a strand arrangement 1 with a first plurality of strands 10 of superconductor material. Figure 4 shows at least one turn 50, specifically turns 100, 101, and 102. Each of these turns 50 may be configured as shown in Figure 2. Turns 100, 101, and/or 102 may be connected by a series connection.

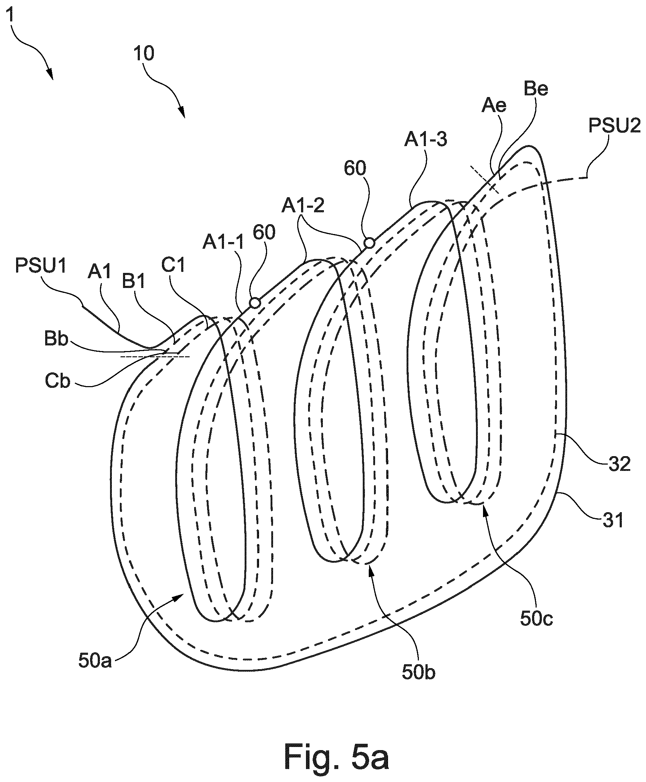

Figure 5a shows an embodiment of a strand arrangement 1, which is optionally for a superconductor magnetic field coil. The strand arrangement comprises a first plurality of strands 10 of superconductor material. The first plurality of strands includes a first strand A1 with a first end Ab and a second end Ae, a second strand B1, and a third strand C1. The strands are arranged in a configuration where the first strand A1, the second strand B1, and the third strand C1 may be enclosed together by a first insulation material. Between these strands, a first ohmic heating material may be arranged to facilitate improved quench behavior.

The figure illustrates the electrical series connections between the strands. Specifically, a first electrical series connection 31 connects the second end Ae of the first strand A1 with the first end Bb of the second strand B1. Additionally, a second electrical series connection 32 connects the second end Be of the second strand B1 with the first end Cb of the third strand C1. These series connections may ensure that the strands are electrically connected in a sequence, forming a continuous electrical path.

The strands are arranged in turns 50a, 50b, 50c. The turns may be part of the coil structure. As shown in Fig. 5a, individual strands may comprise strand segments. For example, as shown for the example of turns in Fig. 5a, joints 60 may connect the strand segments A1-1, A1-2, and A1-3 of the first strand A. These joints may ensure the continuity of the electrical path along the first strand A and optionally along the turns. Also, or alternatively, the other strands may be segmented (not shown).

A power supply unit may be connected at PSU1 and PSU2 to the ends of the strands. In Fig. 5a, PSU1 is connected to the first end of the first strand A1, while PSU2 is connected to the second end of the third strand C1.

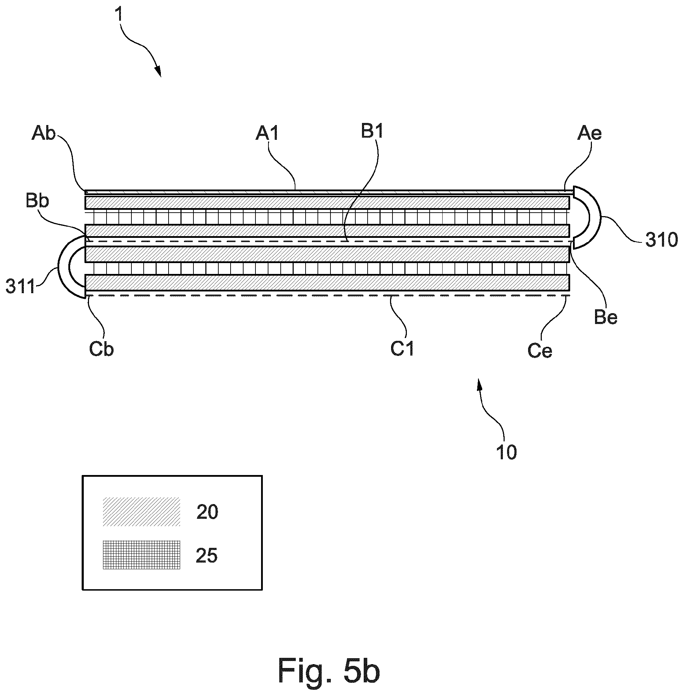

Figure 5b shows a strand arrangement 1 that can function as a bus-bar or be integrated within a larger arrangement, such as a single strand. The strand arrangement may be insulated (not shown). The strand arrangement comprises a first plurality of strands 10, specifically strands A1, B1, and C1. Each strand may be made of superconductor material. The first strand A1 has a first end Ab and a second end Ae. The second strand B1 has a first end Bb and a second end Be. The third strand C1 has a first end Cb and a second end Ce.

The strand arrangement may include a first ohmic heating material 20, which in the figure is positioned between the strands A1, B1, and C1. This material may facilitate controlled heating and ensures proper thermal management within the arrangement, for example during a quench. Additionally, a first metallic stabilizer material 25 is shown extending along the first plurality of strands. This stabilizer material may provide structural support and/or enhances the quench behavior. The arrangement in a cross section view may be similar to the arrangement shown in Fig. 3. In other words, a cable or strand arrangement as shown in Fig. 3 may be used to implement a bus-bar by series connection of the plurality of strands, for example at least two strands, for example three strands, for example four strands.

Electrical series connections are implemented to connect the ends of the strands. A tenth electrical series connection 310 connects the second end Ae of the first strand A1 with the second end Be of the second strand B1. Similarly, an eleventh electrical series connection 311 connects the first end Bb of the second strand B1 with the first end Cb of the third strand C1. These series connections ensure that the strands are electrically connected in a manner that allows current flow from one side of the figure to the other side, thus allowing a bus-bar functionality during regular operation.

As can be seen from Fig. 5b, the arrangement may allow the plurality of strands to self-short-circuit in case superconductivity in at least one strand is lost. Thereby voltage buildup due to collapse of the magnetic field during quenching of a single strand may be reduced due to presence of the ohmic heating material.

Not shown in the figure, the strand arrangement may be enclosed by an insulation material. The insulation material may be partially or fully enclosing the strands, depending on the specific design requirements, for example enclosing the strands along the length but not at the ends of the arrangement 1 shown in Fig. 5b.

The figure illustrates how the strand arrangement can be used as a bus-bar, providing a robust electrical connection between different components. Alternatively, it can be integrated within a larger superconductor magnetic field coil arrangement, functioning as a single strand within a multi-strand configuration.

Fig. 6a, 6b, and 6c show different arrangements 1 of strands which can be superconducting magnetic field coils 2. In the illustrations, turns 50 are shown. For simplicity, a first strand A' and a second strand B' are shown to illustrate a plurality of strands. In Fig. 6a, an insulation 40' is present, while fig. 6b has no insulation. In Fig. 6c a partial insulation 40" is present between turns 50. For example, the partial insulation may be achieved by using an ohmic heating material as described herein. In some examples, the insulation material may be partially or entirely replaced by ohmic heating material. In fig. 6a-6c a metallic stabilizer 25' is also indicated. As described before, the ends of the strand may be defined between a beginning of a turn b and an end of a turn e. A first end of a strand may be defined as at the beginning of the turn, for example at the larger radius and a second end of a strand may be defined as at the end of the turn, for example at the smaller radius as shown in Fig. 6a. However, in other examples an opposite definition or entirely different definitions are possible as well.

Fig. 7 shows a superconductor magnetic field coil 2, in the example of Fig. 7 a pancake coil with turns in a plane following a spiral path. However, in other examples (not shown in Fig. 7 and also not shown in figures below), other coil designs than pancake coils, for example helical coils, may be used. In Fig. 7, the magnetic field coil 2 comprises:
A first plurality of strands A of superconductor material, the first plurality of strands comprising:
a first strand A of the first plurality of strands and a second strand B of the first plurality of strands,
a first ohmic heating material (not shown) arranged between the first strand A of the first plurality of strands and the second strand B of the first plurality of strands,
a first insulation material 40 at least partially enclosing the first plurality of strands. Similar to Fig. 6a, the first insulation material 40 provides a single layer of insulation between turns. In other examples, double layers of insulation or more layers of insulation are possible.

As shown in Fig. 7, the superconductor magnetic field coil 2 may further comprise a first electrical series connection 31 connecting a second end Ae of the first strand A of the first plurality of strands with a first end Bb of the second strand B of the first plurality of strands.

Figure 8a shows a detailed schematic of a strand arrangement for a superconductor magnetic field coil 2. The depicted arrangement 1 may comprise multiple strands of superconductor material, each may be encased in insulation material and connected in series through low-resistance electrical connections. The figure illustrates two double pancake coils, labeled 50a and 50b, which are interconnected to form a continuous electrical path.

Fig. 8a shows a superconductor magnetic field coil 1, preferably a double pancake coil 2, comprising:
A first plurality of strands A, B of superconductor material, the first plurality of strands comprising:
a first strand A of the first plurality of strands and
a second strand B of the first plurality of strands,
a first ohmic heating material arranged between the first strand A of the first plurality of strands and the second strand B of the first plurality of strands,
a first insulation material 40a at least partially enclosing the first plurality of strands.

As shown in Figure 8a, the superconductor magnetic field coil 2 may further comprise a second plurality of strands C, D of superconductor material, the second plurality of strands comprising:
a first strand C of the second plurality of strands and
a second strand D of the second plurality of strands,
a second ohmic heating material 20 arranged between the first strand C of the second plurality of strands and the second strand D of the second plurality of strands,
a second insulation material 40b at least partially enclosing the second plurality of strands.

As shown in Figure 8a, the superconductor magnetic field coil 2 may further comprise a third electrical series connection 33 connecting the second end Ae of the first strand A, A1 of the first plurality of strands with a second end Ce of the first strand C of the second plurality of strands.
the superconductor magnetic field coil 2 may further comprise a fourth electrical series connection 34 connecting a second end Be of the second strand B of the first plurality of strands with a second end De of the second strand D of the second plurality of strands.
the superconductor magnetic field coil 2 may further comprise a fifth electrical series connection 35 connecting a first end Bb of the second strand B of the first plurality of strands with a first end Cb of the first strand C of the second plurality of strands.

The strands are arranged in turns, with the at least one turn 50a comprising turns of the first plurality of strands and the at least one second turn 50b comprising turns of the second plurality of strands. The turns are designed to create a magnetic field when current flows through the strands. The series connections between the strands ensure that the current flows through the entire arrangement, creating a magnetic field.

The metallic stabilizer materials 25a and 25b extend along the length of the strands and are inductively coupled to the corresponding plurality of strands. These stabilizer materials provide additional mechanical support and enhance the stability of the superconductor strands during operation.

As shown in the example of Fig. 8a, no connections cross the coil path. This may simplify the serial connections, for example serial connections 33, 34, and/or 35.

Fig. 8b shows a superconductor magnetic field coil 1, preferably a double pancake coil 2, comprising:
A first plurality of strands A, B of superconductor material, the first plurality of strands comprising:
a first strand A of the first plurality of strands and
a second strand B of the first plurality of strands,
an first ohmic heating material 20 arranged between the first strand A of the first plurality of strands and the second strand B of the first plurality of strands,
a first insulation material 40a at least partially enclosing the first plurality of strands.

A second plurality of strands C, D of superconductor material, the second plurality of strands comprising:
a first strand C of the second plurality of strands and
a second strand D of the second plurality of strands,
a second ohmic heating material 20 arranged between the first strand C of the second plurality of strands and the second strand D of the second plurality of strands,
a second insulation material 40b at least partially enclosing the second plurality of strands.
a third electrical series connection 31 connecting a second end Ae of the first strand A of the first plurality of strands with a first end Bb of the second strand B of the first plurality of strands, and/or
a fourth electrical series connection 34 connecting a second end Be of the second strand B of the first plurality of strands with a second end Ce of the first strand C of the second plurality of strands C,D and/or
a fifth electrical series connection 36 connecting a second end De of the second strand D of the second plurality of strands with a first end Cb of the first strand C of the second plurality of strands C,D.

Fig. 9 shows a superconductor magnetic field coil 1, comprising:
a first double pancake coil 2a, comprising:
a first plurality of strands A, B of superconductor material, the first plurality of strands comprising:
a first strand A of the first plurality of strands and
a second strand B of the first plurality of strands,
a first ohmic heating material 20 arranged between the first strand A of the first plurality of strands and the second strand B of the first plurality of strands,
a first insulation material 40a at least partially enclosing the first plurality of strands.
a second plurality of strands C, D of superconductor material, the second plurality of strands comprising:
   a first strand C of the second plurality of strands and
   a second strand D of the second plurality of strands,
   a second ohmic heating material 20 arranged between the first strand C of the second plurality of strands and the second strand D of the second plurality of strands,
   a second insulation material 40b at least partially enclosing the second plurality of strands,
   a third electrical series connection 33 connecting a second end Ae of the first strand A of the first plurality of strands with a second end Ce of the first strand C of the second plurality of strands, and/or
   a fourth electrical series connection 34 connecting a second end Be of the second strand B of the first plurality of strands with a second end De of the second strand D of the second plurality of strands and/or
   a fifth electrical series connection 35 connecting a first end Bb of the second strand B of the first plurality of strands with a first end Cb of the first strand C of the second plurality of strands;
   a second double pancake coil 2b, comprising:
      a third plurality of strands E, F of superconductor material, the third plurality of strands comprising:
      a first strand E of the third plurality of strands and
      a second strand F of the third plurality of strands,
      a third ohmic heating material 20 arranged between the first strand E of the third plurality of strands and the second strand F of the third plurality of strands,
      a third insulation material 40a at least partially enclosing the third plurality of strands.
      a fourth plurality of strands G, H of superconductor material, the fourth plurality of strands comprising:
         a first strand G of the fourth plurality of strands and
         a second strand H of the fourth plurality of strands,
         a fourth ohmic heating material 20 arranged between the first strand G of the fourth plurality of strands and the second strand H of the fourth plurality of strands,
         a fourth insulation material 40b at least partially enclosing the fourth plurality of strands,
         a sixth electrical series connection 33 connecting a second end Ee of the first strand A of the third plurality of strands with a second end Ge of the first strand G of the fourth plurality of strands, and/or
         a seventh electrical series connection 34b connecting a second end Fe of the second strand F of the third plurality of strands with a second end He of the second strand H of the fourth plurality of strands and/or
         an eighth electrical series connection 35b connecting a first end Fb of the second strand F of the second plurality of strands with a first end Gb of the first strand G of the third plurality of strands;
         further comprising:
            a ninth electrical series connection 39 connecting a first end Db of the second strand D of the second plurality of strands with a first end Eb of the first strand E of the third plurality of strands.

As illustrated, the strand arrangements of Fig. 7, Fig. 8a, Fig. 8b, and/or Fig. 9 may be powered by a power supply 70 and connected by leads 71 and 72. Lead 71 and/or lead 72 may be embodied by a bus-bar as described herein, for example as shown in Fig. 5b.

In the following, with reference to Fig. 10, 11, and 12, different connection options for ohmic heating material and/or metallic stabilizers will be discussed. In the following, reference is predominantly made to metallic stabilizers. In some examples, the following applies to both ohmic heating materials and metallic stabilizers. In other examples, an ohmic heating material replaces the metallic stabilizer discussed. In yet other examples, the following applies only to the metallic stabilizer.

Figure 10 shows a schematic representation of a different connection options for example for coil 2 shown in Fig. 8a and/or Fig. 8b. The series connections of the strands are not shown in Fig. 10 for clarity. As for example in Fig. 8a, Fig. 10 shows a double pancake coil with turns/ "pancakes " 50a and 50b.

The first pancake coil 50a includes strands A and B, which are part of the first plurality of strands as explained before, for example with reference to Fig. 8a. Likewise, the second pancake 50b may comprise strands C and D, which may be part of the second plurality of strands as explained above.

Connection 26a links first end of the first stabilizer material 25a to a second end of the first metallic stabilizer material. Connection 26b links the first end of second stabilizer material 25b to a second end of second stabilizer material 25b. Thus, the stabilizer material of first pancake and/or the second pancake may form a closed loop which may improve quench behavior of the double pancake coil.

Figure 11 is similar to Fig. 10 unless described otherwise. Fig. 11 shows a different connection of the metallic stabilizers than fig. 10, namely connections 27a and 27b. As shown in Fig. 11, series connections 27a and 27b connect first and second stabilizer material 25a, 25b in series between the at least one turn 50a and the second turn 50b of coil 2. In this example, the second turn 50b is a turn of at least one turn 50b of the second plurality of strands.

Figure 12 shows a further connection scheme for the metallic stabilizer materials, for example in the coil 2 shown in Fig. 9 with labels from Fig. 9 omitted for clarity. As in Fig. 9, Fig. 12 shows a first double pancake coil 2a and a second double pancake coil 2b. The metallic stabilizers may be connected as follows: The first metallic stabilizer may be connected by connection 26a, thereby forming a loop over the at least one turn (in the figure, three exemplary turns are shown).

Likewise, connection 26b connects the second metallic stabilizer 25b, also forming a closed loop. In addition, connection 28a connects the first metallic stabilizer and the second metallic stabilizer.

For the second double pancake coil 2b the situation is similar. Connection 26c connects the third metallic stabilizer 25c and/or connection 26d connects the fourth metallic stabilizer 25d. Optionally, connection 28c connects the third metallic stabilizer and the fourth metallic stabilizer as shown.

In addition, connection 28b may connect the first double pancake coil 2a and a second double pancake coil 2b, for example by connecting the first end of the second metallic stabilizer to the first end of the third metallic stabilizer as shown.

In some examples, all of the above connections are present. In other examples, not all of the exemplary connections are present.

Fig. 13 shows a double pancake coil according to an example.

As shown in Fig. 13, a strand arrangement, optionally for a superconductor magnetic field coil, may comprise:
- a first plurality of strands 10 of superconductor material, the first plurality of strands comprising:
   a first strand of the first plurality of strands with a first end and a second end,
   a second strand of the first plurality of strands,
   a first ohmic heating material arranged between the first strand of the first plurality of strands and the second strand of the first plurality of strands,
   a first insulation material 40a at least partially enclosing the first plurality of strands.

The strand arrangement may further comprise:
a second plurality of strands 11 of superconductor material, the second plurality of strands comprising:
a first strand of the second plurality of strands and
a second strand of the second plurality of strands,
a second ohmic heating material arranged between the first strand of the second plurality of strands and the second strand of the second plurality of strands,
a second insulation material 40b at least partially enclosing the second plurality of strands;
As shown in Fig. 13, the strand arrangement 1 may be a double pancake coil with a first pancake with at least one turn 50a formed from the first plurality of strands 10 and the second plurality of strands 11. As shown in Fig. 13, the first and second insulation material 40a, 40b may act together to enclose the first and second plurality of strands.

As noted above, other arrangements than a pancake structure may be used, for example coils with non-spiral windings, for example with helical windings.

As shown in Fig. 13, the first plurality of strands 10 and the second plurality of strands 11 may arranged with parallel along the at least one turn 50a. In the example of Fig. 13, three turns are shown. Likewise, the second pancake may be formed but the second pancake may also be omitted or made differently.

As shown in Fig. 13, the strand arrangement 1 may further comprise:
- a third plurality of strands 12 of superconductor material, the third plurality of strands comprising:
   a first strand of the third plurality of strands and
   a second strand of the third plurality of strands,
   a third ohmic heating material arranged between the first strand of the third plurality of strands and the second strand of the third plurality of strands,
   a third insulation material 40c at least partially enclosing the third plurality of strands.
- a fourth plurality of strands 13 of superconductor material, the fourth plurality of strands comprising:
   a first strand of the fourth plurality of strands and
   a second strand of the fourth plurality of strands,
   a fourth ohmic heating material arranged between the first strand of the fourth plurality of strands and the second strand of the fourth plurality of strands,
   a fourth insulation material 40d at least partially enclosing the fourth plurality of strands.

The third plurality of strands and the fourth plurality of strands may form a second pancake coil as shown in Fig. 13.

Note that in fig. 13 the first, second, third, and/or fourth plurality of strands 10,11,12,13 are shown without showing the additional components. As described before, the arrangement may further comprise additional components, for example metallic stabilizer material as described herein.

Also, as described herein and as also valid for the other examples, the first, second, third, and/or fourth plurality of strands 10,11,12,13 may in some examples be cables comprising identical or similar components, for example cables as described in the Annex.

Similar to the configuration shown in Fig. 8a but also differently, the plurality of strands may have series connections. For example, the first plurality of strands 10 may be connected similar to the series connection shown in Fig. 8a with the second plurality of strands of fig. 8a corresponding to the third plurality of strands in Fig. 13. Likewise, the second plurality of strands may be connected in a similar manner.

In some examples and as shown in Fig. 13, the first plurality of strands 10 may be series connected to the third plurality of strands 12 via connection 312, the second plurality of strands 11 may be series connected to the fourth plurality of strands via connection 313. The third plurality of strands 12 may be series connected to the second plurality of strands 11 via series connection 314. The fourth plurality of strands 13 may be series connected to the first plurality of strands 10 via series connection 315.

A series connection of a plurality of strands with another plurality of strands may be a series connection of each individual strand of the respective plurality of strands with each other. In other examples, such a series connection may also cross strands of the plurality of strands. Further, additional connections may be included, for example to a power supply.

Examples for such series connections between plurality of strands are shown in Fig. 14a and Fig. 14b.

As shown in Fig. 14a, the a series connection of pluralities of strands may for example be a series connection 312 which connects the first plurality of strands 10 with a third plurality of strands 12. As illustrated in fig. 14a, the first plurality of strands may comprise a first strand A of the first plurality of strands and a second strand B of the first plurality of strands. The first plurality of strands 10 may comprise further elements as described herein, for example first metallic stabilizer material 25a. Further elements may be present, for example first ohmic heating material and/or first insulation material (not shown). As shown in fig. 14a, all these elements may be connected element-wise in a series connection, for example of the respective elements of the third plurality of strands 12, for example first metallic stabilizer material 25a to fourth metallic stabilizer material 25d etc. This series connection 312 may be series connection 312 of fig. 13. The series connection 313 of fig. 13 may be identical or similar but also different, for example as explained below.

Fig. 14b shows a different example for a series connection of pluralities of strands. In Fig. 14b, at least one of the plurality of strands is switched. In the example of Fig. 14b shown, the first strand E of the fourth plurality of strands 12 is connected to the second strand B of the first plurality of strands 10. At the same time, the second stand F of the fourth plurality of strands 12 is connected to the first strand A of the first plurality of strands 10. In other words, while connection shown in Fig. 14a connects first strands of the pluralities of strands and second strands of the pluralities of strands with each other (A->E, B->F), Fig. 14b performs a cross connection (A->F, B->E). In addition but purely optional, Fig. 14b shows that a power supply 70 may be connected using leads 71, 72 and optional switch 73.

While explained with reference to Fig. 13, the serial connections explained with reference to Fig. 14a and/or Fig. 14b may also be used for series connections in other examples described herein, for example in Fig. 8a, Fig. 7 etc.

Such double pancake coils as described herein, for example as explained with reference to Fig. 13 and Fig. 14a and 14b may be used in a stellarator. Notably, a plurality of single pancake coils or double pancake coils may be used connected in series, for example using a single power supply, for example power supply 70 connected via a series connection as explained above. The principle explained above for the simple case of two strands in the plurality of strands may be expanded to more strands as explained herein. Also, the above was explained for a two in hand winding pancake coil in which two pluralities of strands 10, 11 are used to form a single pancake coil. In other embodiments, more pluralities of strands are used, for example 3, 4, 5, 6, 7, 8, 9, or 10.

In one example, a resistance R of a closed loop over the connected metallic stabilizer materials, for example as illustrated in Fig. 11 for a single winding but also possible for the two-in-hand winding shown in Fig. 13, may be designed so that a current decay time constant given by L/R, where L is the inductance of the stabilizer coil has a first value.

In a setup with multiple arrangements, for example multiple double pancake coils or other arrangements or coils as explained herein, the time constant of the individual arrangements may be designed to be similar or identical for the full setup.

This may allow to ensure that all the coils or arrangements de-energize together which may reduce forces during quench conditions.

Notably, the resistance can be tuned at the design stage, for example chosen to compensate for the different inductances of the coils, so that L/R may be similar or identical regardless of the shape, size, and number of turns, for example in different stellarator coils. In addition or alternatively, the resistance may be adjusted during manufacturing, based on measurements on each coil. In addition or alternatively, in cases where the metallic stabilizer material forms a loop which is arranged to exit a cryostat to room temperature, an adjustment in real time based on measurements of current and or magnetic field is possible. This may allow dynamic balancing of the forces in the stellarator using such coils, for example during operation.

In one example a stellarator with a plurality of superconductor magnetic field coils is provided. The magnetic field coils may comprise or be magnetic field coils according to examples described herein. Each of the superconductor magnetic field coils of the plurality of magnetic field coils may have a common current decay time constant. In some examples, the plurality of magnetic field coils have different individual inductances, for example L_coil_i, for an ith coil of the plurality of superconductor magnetic field coils and different individual coil resistances, R_coil_i for an an ith coil of the plurality of superconductor magnetic field coils, wherein the ratio ti=L_coil_i/R_coil_i is essentially identical for the plurality of superconductor magnetic field coils in the stellarator.

The examples from the description above may be combined. For example, one or both of the cables 71, 72 connecting to the power supply shown in Fig. 8a may be at least partially embodied by an arrangement similar to the bus-bar system schematically illustrated in Fig. 5b. This applies for the other cables shown in other figures as well. In some embodiments, a single strand, for example strand A in Fig. 9 may also be embodied by a plurality of strands or strand segments itself. As a simple example, the turned strang A of the first plurality of strands shown in Fig. 9 may be embodied by strands A1, B1, C1 and ohmic heating material 20 and/or metallic stabilizer material as schematically shown in Fig. 5b. This applies to the other strands described herein, for example strands A1, B1, B2, A-H etc.

The invention may be further characterized by the following examples as well as the further examples in the Annexes.

### Examples:

Example 1. A superconductor magnetic field coil, comprising:
- a plurality of strands of superconductor material, the plurality of strands comprising:
   - a first strand of the plurality of strands and
   - a second strand of the plurality of strands,
- an ohmic heating material arranged between the first strand of the plurality of strands and the second strand of the plurality of strands, optionally comprising:
- a first electrical series connection, optionally connecting an ending of the first strand of the plurality of strands with a beginning of the second strand of the plurality of strands, and optionally comprising
- an insulation material at least partially enclosing or enclosing the plurality of strands.

Example 2. The superconductor magnetic field coil of example 1, further comprising:
- a metallic stabilizer material extending along the plurality of strands,
- and optionally wherein the ohmic heating material is arranged between the plurality of strands and the metallic stabilizer material.

Example 3. The superconductor magnetic field coil of example 1 or example 2, wherein the plurality of strands are arranged in at least one turn and/or
wherein the at least one turn comprises a plurality of turns and, optionally,
wherein the plurality of turns comprises one of the following:
   - at least 3 turns, at least 5 turns, at least 10 turns, at least 20 turns, at least 50 turns, at least 100 turns, at most 1000 turns.

Example 4. The superconductor magnetic field coil of any of the previous examples, wherein at least one strand of the plurality of strands is divided into a plurality of strand segments, and, optionally, the strand segments are connected with each other in a series connection to form the strand,
wherein, optionally, the strand segments are connected by joints between turns of the at least one turn.

Example 5. The superconductor magnetic field coil of any of the previous examples, further comprising:
- a third strand of the plurality of strands,
wherein the ohmic heating material is arranged between the first strand of the plurality of strands and the second strand of the plurality of strands and the third strand of the plurality of strands,
- a second electrical series connection connecting an ending of the second strand of the plurality of strands with a beginning of the third strand of the plurality of strands.

Example 6. The superconductor magnetic field coil of any of the previous examples, wherein the first electrical series connection and/or the second electrical series connection and/or further electrical series connections between strands of the plurality of strands is provided by a first joint, wherein:
- the first joint has a first resistance below 1 µOhm, preferably below 50 nOhms, preferably below 10 nOhms and/or
- the first joint has a first resistance value at least 10 times lower, optionally 100 times lower, optionally at least 1000 times lower, than the resistance between two strands of the plurality of strands.

Example 7. The superconductor magnetic field coil of any of examples 3 to 6, wherein the metallic stabilizer material is at least one of the following:
- arranged along the coil, inductively coupled to the plurality of strands,
- arranged to form a loop between a first end of the coil and a second end of the coil,
- comprising a first metallic stabilizer material arranged in a closed loop within a single turn of the at least one turn;
- connected in series between the at least one turn and the second turn;
- forming a loop for the at least one turn and/or the second turn.

Example 8. The superconductor magnetic field coil of any of examples 3 to 7, wherein the at least one turn comprises a plurality of turns, wherein the metallic stabilizer material is arranged in at least one turn of the plurality of turns as a secondary winding for an induction created by a change of current in the plurality of strands in another turn of the plurality of turns.

Example 9. The superconductor magnetic field coil of any of the previous examples, further comprising a second metallic stabilizer electrically insulated from the plurality of strands, optionally insulated by the insulation material,
wherein the second metallic stabilizer is arranged as a secondary winding for an induction created by a change of current in the plurality of strands and, optionally, provides a structural support for the superconductor magnetic field coil.

Example 10. The superconductor magnetic field coil of any of the previous examples, wherein the plurality of strands comprises between 2 and 10 strands.

Example 11. The superconductor magnetic field coil of example 10, wherein the plurality of strands comprise:
- between 2 and 4 strands; or between 4 and 6 strands; or between 6 and 8 strands; or between 8 and 10 strands.

Example 12. The superconductor magnetic field coil of any of the previous examples when dependent on example 3 and example 4, wherein:
- the at least one turn comprises a first turn and a second turn and wherein the plurality of strand segments within the first turn are connected in series with a plurality of strand segments of the second turn
   and/or
- wherein the plurality of strand segments of the at least one turn are connected in series within the at least one turn.

Example 13. The superconductor magnetic field coil according to any of the previous examples, wherein the superconductor material comprises a high temperature superconductor material, optionally a high temperature superconductor tape, optionally rare earth barium copper oxide, ReBCO, tape.

Example 14. A superconductor magnetic field coil, comprising:
- one or more insulated plurality of superconductor strands arranged in at least one turn, wherein each of the one or more plurality of superconductor strands is electrically connected in series by low-resistance inter-strand joints, such that the plurality of superconductor strands behaves as a non-insulated, NI, coil with a number of turns corresponding to the number of strands connected in series
   and/or
- an ohmic heating material arranged between the plurality of superconductor strands and a metallic stabilizer material, wherein the ohmic heating material and the metallic stabilizer material provide an ohmic heating path along the one or more plurality of superconductor strands.

Example 15. The superconductor magnetic field coil of example 14, wherein the metallic stabilizer material comprises at least one of the following:
- connections formed by the metallic stabilizer material between a first and a second end of the superconductor magnetic field coil;
- one or more first sets of metallic stabilizer material, each set of the one or more first sets of metallic stabilizer material arranged to form a closed loop within a single turn of the at least one turn;
- one or more second sets of metallic stabilizer material, each set of the one or more second sets of metallic stabilizer material arranged with one of the one or more of the plurality of superconductor strands to form a resistive coil inductively coupled to the one of the one or more of the plurality of superconductor strands;
- connections between a first selection or all of the first sets of metallic stabilizer material and a second selection or all of the second sets of metallic stabilizer material.

Example 16. A superconductor magnetic field coil according to any of the previous examples, wherein the ohmic heating material has a surface resistivity between 10⁻⁷ Ohm·m² and 1 Ohm·m².

### Annexes

As described above, in the following Annexes A, and B, C, examples are provided. For the various examples above, the plurality of strands of superconductor material, the ohmic heating material, the insulation material and/or the metallic stabilizer material may be provided as one or more superconductor cables according to the examples provided below. Combinations are also possible as well. For example, the first plurality of strands of superconductor material, the first ohmic heating material, the first insulation material and/or the first metallic stabilizer material may provided according to one or more examples of Annex A and/or the second plurality of strands of superconductor material, the second ohmic heating material, the second insulation material and/or the second metallic stabilizer material may be provided according to one or more examples according to Annex B etc. The same applies for Annex C.

The aforementioned metallic stabilizer materials, for example the first metallic stabilizer material, second metallic stabilizer material, third metallic stabilizer material, and/or fourth metallic stabilizer material may have the properties described in the examples below, for example of the layers of the examples of metallic stabilizer material below. As a example, the first metallic stabilizer material may have the properties disclosed in Example 11 of Annex A and thus may comprise at least one of the following materials: solder, copper, copper alloy, brass, aluminium, aluminium alloy. The same may apply for the other metallic stabilizer materials disclosed herein. As described, the metallic stabilizer materials may be layers or bulk material according to the examples.

Also, combinations are possible.

The following examples are described in detail in European Patent Application of 15 November 2024, application number EP24213309.8, "SUPERCONDUCTOR CABLE FOR A SUPERCONDUCTOR CABLE ASSEMBLY AND RELATED SYSTEM AND METHOD" (Annex A) and European Patent Application of 16 December 2024 of the same title, application number EP24220203.4 (Annex B and C), which are incorporated by reference herewith in their entirety. The incorporation by reference is not limited to the specific Annexes.

### Annex A

Example 1. A superconductor cable (21) for a superconductor cable assembly (22), comprising:
a superconductor region, the superconductor region comprising:
high temperature superconductor material, optionally high temperature superconductor tapes (23) and
a first metallic stabilizer material (24); the superconductor cable further comprising:
   a layer of ohmic heating material (25) at least partially surrounding the superconductor region;
   wherein the layer of ohmic heating material (25) has a surface resistivity between 10⁻⁷ Ohm · m² and 1 Ohm m², optionally between 10⁻⁷ Ohm·m² and 1 Ohm·m², optionally between 10⁻⁶ Ohm·m² and 10⁻¹ Ohm·m², optionally between 10⁻⁵ Ohm·m² and 10⁻² Ohm·m², optionally between 10⁻⁴ Ohm·m² and 10⁻³ Ohm·m², optionally between 2 · 10⁻⁴ Ohm·m² and 5 · 10⁻⁴ Ohm·m², optionally of approximately 3 · 10⁻⁴ Ohm·m²; and/or
      and/or
   wherein the layer of ohmic heating material (25) has a surface resistivity between 10⁻⁷ Ohm·m² and 3·10⁻⁴ Ohm·m², optionally between 5 · 10⁻⁷ Ohm·m² and 1.5 · 10⁻⁴ Ohm·m², optionally between 1 · 10⁻⁶ Ohm·m² and 7.5 · 10⁻⁵ Ohm·m², optionally between 5 · 10⁻⁶ Ohm·m² and 3 · 10⁻⁵ Ohm·m², optionally between 10⁻⁵ Ohm·m² and 1.5 · 10⁻⁵ Ohm·m², optionally between 3 · 10⁻⁵ Ohm·m² and 1 · 10⁻⁵ Ohm·m²
      and /or
   wherein the layer of ohmic heating material (25) has a surface resistivity between 3 · 10⁻⁴ Ohm·m² and 1 Ohm·m², optionally between 1 · 10⁻³ Ohm·m² and 3 · 10⁻¹ Ohm·m², optionally between 3 · 10⁻³ Ohm·m² and 1 · 10⁻¹ Ohm·m², optionally between 1 · 10⁻² Ohm·m² and 3 · 10⁻² Ohm·m², optionally between 3 · 10⁻² Ohm·m² and 1 · 10⁻¹ Ohm·m², optionally between 1 · 10⁻¹ Ohm·m² and 3 · 10⁻¹ Ohm·m².

Example 2. The superconductor cable (21) of example 1, further comprising: a layer of second metallic stabilizer material (26), wherein the layer of ohmic heating material (25) is arranged at least partially or entirely between the superconductor region and the layer of second metallic stabilizer material (26) and/or
wherein the surface resistivity of the ohmic heating material (25) is defined between the superconductor region and the layer of second metallic stabilizer material (26).

Example 3. The superconductor cable (21) of example 1 or example 2,
wherein the layer of ohmic heating material (25) entirely surrounds the superconductor region
   and/or
wherein the layer of ohmic heating material (25) is arranged in between the superconductor region and the second metallic stabilizer material (26);
   and/or
wherein the layer of ohmic heating material (25) has a thickness between 0.01 mm to 10 mm.

Example 4. The superconductor cable (21) of any of examples 1 to 3,
wherein, when from a first position along the superconductor cable to a second position along the superconductor cable the high temperature superconductor material is in a non-superconducting state, the superconductor cable (21) has:
   a first resistance, Rnz, determined for current passing through the superconductor region from the first position to the second position and
   a second resistance, Rbypass, determined for current not passing through the superconductor region from the first position to the second position;
and wherein a ratio Rnz to Rbypass is at least 1.

Example 5. The superconductor cable (21) of any of examples 2 to **4,** further comprising:
a layer of insulation material (27) at least partially surrounding the layer of second metallic stabilizer material (26), wherein the layer of insulation material (27) has a resistivity of at least 1 · 10⁴ Ohm · m.

Example 6. The superconductor cable (21) of any of examples 1 to 5, wherein the superconductor cable (21) further comprises:
at least one second high temperature superconductor material, optionally at least one second stack of high temperature superconductor tapes (23b) and/or
at least one third high temperature superconductor material, optionally at least one third stack of high temperature superconductor tapes (23c); and/or

at least one fourth high temperature superconductor material, optionally at least one fourth stack of high temperature superconductor tapes (23d);
wherein, optionally, the high temperature superconductor material, the at least one second high temperature superconductor material, the at least one third high temperature superconductor material and/or the at least one fourth high temperature superconductor material are one or more of the following:
   electrically insulated from each other,
   electrically connected with each other,
   connected by a third metallic stabilizer material (24c),
   at least partially or entirely surrounded by the layer of ohmic heating material (25).

Example 7. The superconductor cable (21) of any of examples 1 to 6, wherein the high temperature superconductor material (23) and/or the at least one second high temperature superconductor material and/or the at least one third high temperature superconductor material and/or the at least one fourth high temperature superconductor material is twisted along a length of the superconductor cable (21).

Example 8. The superconductor cable (21) of any of examples 1 to 7, wherein the first metallic stabilizer material (24) further comprises a metallic jacket layer (24b).

Example 9. The superconductor cable (21) of any of examples 1 to 8, wherein along a length (LD) of the superconductor cable (21):
the resistivity of the ohmic heating material (25) changes and/or
a local thickness of the ohmic heating material (25) changes.

Example 10. The superconductor cable of example 9, wherein the local thickness and/or resistivity of the ohmic heating material (25) in a region at the start (R1) along the length of the superconductor cable (21) and/or in a region at the end (R2) along the length of the superconductor cable (21) are different from the local thickness and/or resistivity of the ohmic heating material in a region in the middle (R3) along the length of the superconductor cable.

Example **11.** The superconductor cable (21) of any of examples 1 to 10, wherein
the first metallic stabilizer material (24) comprises at least one of the following materials: solder, copper, copper alloy, brass, aluminium, aluminium alloy and/or
the layer of ohmic heating material (25) comprises at least one of the following materials:silicon carbide, semi-metals, semiconductors, anodised aluminium, matrix composites and/or
the layer of second metallic stabilizer (26) material comprises at least one of the following materials: solder, copper, copper alloy, brass, aluminium or aluminium alloy, a high-strength material, steel; and/or
the optional layer of insulation material (27) comprises at least one of the following materials: organic insulators, polyimide, inorganic insulators, ceramic, non-conductive epoxy, a glass fibre matrix, insulation paper, insulating lacquer, paint.

Example 12. A superconductor cable assembly (22), preferably a superconductor magnetic field coil (20, 20a, 20b), comprising a plurality of turns (31, 32, 33) of a superconductor cable (21) and/or a plurality of superconductor cables (21, **41,** 42) according to any of examples 1 to 11.

Example 13. A superconductor cable assembly (22) comprising at least one superconductor cable (21), the at least one superconductor cable (21) comprising:
a superconductor region, the superconductor region comprising:
   high temperature superconductor material, optionally high temperature superconductor tapes (23) and
   a first metallic stabilizer material (24); the superconductor cable further comprising:
a layer of ohmic heating material (25) at least partially surrounding the superconductor region;
the superconductor cable assembly (22) further comprising:
a layer of second metallic stabilizer material (26) at least partially or entirely surrounding the layer of ohmic heating material (25);
wherein a thickness and resistivity of the layer of ohmic heating material (25) are configured such that a first velocity (v1) of a non-superconducting zone propagation along the superconductor cable (21) is larger than a second velocity (v2) of non-superconducting zone propagation in a radial direction of the superconductor cable assembly (22).

Example 14. The superconductor cable assembly (22) of example 13, wherein the superconductor cable assembly (22) is a magnetic field coil (20, 20a, 20b) comprising a plurality of turns (31, 32, 33) of the at least one superconductor cable (21) and/or wherein the radial direction of the superconductor cable assembly (22) is a direction perpendicular to a local direction along at least one of the plurality of turns (31, 32, 33).

Example 15. The superconductor cable assembly (22) of example 14,
wherein a ratio of the first velocity (v1) to the second velocity (v2) is configured such that a locally formed non-superconducting zone (50) in one of the turns (31, 32, 33) of the plurality of turns propagates along a substantial distance of the turn before an adjacent turn becomes non-superconducting.

Example 16. The superconductor cable assembly (22) of any of examples 12 to 15, wherein the superconductor cable assembly (22) further comprises:
a layer of insulation material (27) surrounding the layer of second metallic stabilizer material (26), wherein the layer of insulation material (27) has a resistivity of at least 1 · 10⁴ Ohm · m.

Example 17. The superconductor cable assembly (22) of any of examples 12 to 16, wherein the second metallic stabilizer (26) further comprises a conductive support structure (26a), wherein:
the superconductor cable is embedded in the conductive support structure (26a) and/or
the conductive support structure (26a) comprises at least one of the following materials: stainless steel, titanium, composite carbon fibre, inconel, nitronic alloy, high strength alloys.

Example 18. The superconductor cable assembly (22) of any of examples 12 to 17, wherein the superconductor cable assembly (22) is a planar magnetic field coil (20a) or a non-planar magnetic field coil (20b) for a stellarator (1).

Example 19. System (100) for preventing damage to at least one superconductor cable assembly (22) of any of examples 12 to 18, the system comprising:
at least one sensor (110) connected to the at least one superconductor cable assembly (22);
   a power control unit (130) connected to the at least one superconductor cable assembly (22);
at least one non-superconducting zone generation means (140) connected to the at least one superconductor cable assembly (22);
   optionally, a dump circuitry (150);and
a control unit (120), operably connected to the at least one sensor (110), the power control unit (130),the at least one non-superconducting zone generation means (140) and optionally connected to the dump circuitry (150), the control unit (120) configured to:
   determine that a local non-superconducting zone (50) has developed in at least one of the at least one superconductor cable assembly (22) based on the at least one sensor (110);
   optionally, interrupt a connection to a power control unit (130) of the at least one superconductor cable assembly (22);
   optionally, activate the non-superconducting zone generation means (140) to generate at least one additional non-superconducting zone in the at least one superconductor cable assembly (22), and
   optionally, connect a dump circuitry (150) to the at least one superconductor cable assembly (22).

Example 20. The system of example 19, wherein the non-superconducting zone generation means (140) is at least one of the following:
at least one heating element attached to the at least one superconductor cable assembly (22)
at least one alternating current generation means coupled to the at least one superconductor cable assembly (22),
and wherein the control unit (120) is further configured to:
activate the at least one heating element and/or the at least one alternating current generation means to generate the at least one additional non-superconducting zone.

Example 21. A method (1200) for preventing damage to at least one superconductor cable assembly (22), comprising the following steps:
determining (S1) that a local non-superconducting zone (50) has developed in the at least one superconductor cable assembly (22);
interrupting (S2) a connection of a power control unit (130) with the at least one superconductor cable assembly (22);
optionally, activating (S3) a non-superconducting zone generation means (140) to generate at least one additional non-superconducting zone;
optionally, connecting (S4) a dump circuitry (150) to the at least one superconductor cable assembly (22).

Example 22. The method of example 21, wherein the non-superconducting zone generation means (140) is at least one of the following:
at least one heating element (140) attached to the at least one superconductor cable assembly (22),
at least one alternating current generation means coupled to the at least one superconductor cable assembly (22).

Example 23. The method of example 21 or example 22, wherein the at least one superconductor cable assembly (22) comprises a plurality of superconductor cable assemblies and wherein the method further comprises:
in response to the determining that a local non-superconducting zone (50) has developed in the at least one superconductor cable assembly (22):
performing at least one of the steps of interrupting, activating and connecting for all of the plurality of superconductor cable assemblies.

Example 24. A superconductor cable (21) for a superconductor cable assembly (22), comprising:
a superconductor region, the superconductor region comprising:
high temperature superconductor material, optionally high temperature superconductor tapes (23) and
a first metallic stabilizer material (24); the superconductor cable further comprising:
   a layer of ohmic heating material (25) at least partially surrounding the superconductor region.

Example 25. The superconductor cable (21) of example 24, wherein
the layer of ohmic heating material (25) has a surface resistivity between 10⁻⁷ Ohm·m² and 1 Ohm·m², optionally between 10⁻⁷ Ohm·m² and 1 Ohm·m², optionally between 10⁻⁶ Ohm·m² and 10⁻¹ Ohm·m², optionally between 10⁻⁵ Ohm·m² and 10⁻² Ohm·m², optionally between 10⁻⁴ Ohm·m² and 10⁻³ Ohm·m², optionally between 2 · 10⁻⁴ Ohm·m² and 5 · 10⁻⁴ Ohm·m², optionally of approximately 3 · 10⁻⁴ Ohm·m²; and/or
   and/or
wherein the layer of ohmic heating material (25) has a surface resistivity between 10⁻⁷ Ohm·m² and 3·10⁻⁴ Ohm m², optionally between 5 ·10⁻⁷ Ohm·m² and 1.5 · 10⁻⁴ Ohm·m², optionally between 1 · 10⁻⁶ Ohm·m² and 7.5 · 10⁻⁵ Ohm·m², optionally between 5 · 10⁻⁶ Ohm·m² and 3 · 10⁻⁵ Ohm·m², optionally between 10⁻⁵ Ohm·m² and 1.5 · 10⁻⁵ Ohm·m², optionally between 3 · 10⁻⁵ Ohm·m² and 1 · 10⁻⁵ Ohm·m²
   and /or
wherein the layer of ohmic heating material (25) has a surface resistivity between 3 · 10⁻⁴ Ohm·m² and 1 Ohm·m², optionally between 1 · 10⁻³ Ohm·m² and 3 · 10⁻¹ Ohm·m², optionally between 3 · 10⁻³ Ohm·m² and 1 · 10⁻¹ Ohm·m², optionally between 1 · 10⁻² Ohm·m² and 3 · 10⁻² Ohm·m², optionally between 3 · 10⁻² Ohm·m² and 1 · 10⁻¹ Ohm·m², optionally between 1 · 10⁻¹ Ohm·m² and 3 · 10⁻¹ Ohm·m².

Example 26. The superconductor cable (21) of example 24 or 25, wherein the superconductor cable (21) further comprises features according to at least one of examples 2 to 11.

In this specification, example embodiments have been presented in terms of a selected set of details. However, a skilled person of ordinary skill in the art would understand that many other example embodiments may be practiced which include a different selected set of these details. It is intended that the following claims cover all possible example embodiments.

### Annex B

In this Annex B, further examples are provided. As stated above, each of the plurality of strands may be provided one or more superconductor cables as described in the following examples.

Example 1. A superconductor cable (21) for a superconductor cable assembly (22), comprising:
a superconductor region, the superconductor region comprising:
high temperature superconductor material, optionally high temperature superconductor tapes (23) and
a first metallic stabilizer material (24); the superconductor cable further comprising:
   a layer of ohmic heating material (25) at least partially surrounding the superconductor region;
   wherein the layer of ohmic heating material (25) has a surface resistivity between 10⁻⁷ Ohm · m² and 1 Ohm · m², optionally between 10⁻⁷ Ohm·m² and 1 Ohm·m², optionally between 10⁻⁶ Ohm·m² and 10⁻¹ Ohm·m², optionally between 10⁻⁵ Ohm·m² and 10⁻² Ohm·m², optionally between 10⁻⁴ Ohm·m² and 10⁻³ Ohm·m², optionally between 2 · 10⁻⁴ Ohm·m² and 5 · 10⁻⁴ Ohm·m², optionally of approximately 3 · 10⁻⁴ Ohm·m²; and/or
      and/or
   wherein the layer of ohmic heating material (25) has a surface resistivity between 10⁻⁷ Ohm·m² and 3·10⁻⁴ Ohm·m², optionally between 5 · 10⁻⁷ Ohm·m² and 1.5 · 10⁻⁴ Ohm·m², optionally between 1 · 10⁻⁶ Ohm·m² and 7.5 · 10⁻⁵ Ohm·m², optionally between 5 · 10⁻⁶ Ohm·m² and 3 · 10⁻⁵ Ohm·m², optionally between 10⁻⁵ Ohm·m² and 1.5 · 10⁻⁵ Ohm·m², optionally between 3 · 10⁻⁵ Ohm·m² and 1 · 10⁻⁵ Ohm·m²
      and /or
   wherein the layer of ohmic heating material (25) has a surface resistivity between 3 · 10⁻⁴ Ohm·m² and 1 Ohm·m², optionally between 1 · 10⁻³ Ohm·m² and 3 · 10⁻¹ Ohm·m², optionally between 3 · 10⁻³ Ohm·m² and 1 · 10⁻¹ Ohm·m², optionally between 1 · 10⁻² Ohm·m² and 3 · 10⁻² Ohm·m², optionally between 3 · 10⁻² Ohm·m² and 1 · 10⁻¹ Ohm·m², optionally between 1 · 10⁻¹ Ohm·m² and 3 · 10⁻¹ Ohm·m².

Example 2. The superconductor cable (21) of example 1, further comprising: a layer of second metallic stabilizer material (26), wherein the layer of ohmic heating material (25) is arranged at least partially or entirely between the superconductor region and the layer of second metallic stabilizer material (26) and/or
wherein the surface resistivity of the ohmic heating material (25) is defined between the superconductor region and the layer of second metallic stabilizer material (26).

Example 3. The superconductor cable (21) of example 1 or example 2,
wherein the layer of ohmic heating material (25) entirely surrounds the superconductor region
   and/or
wherein the layer of ohmic heating material (25) is arranged in between the superconductor region and the second metallic stabilizer material (26);
   and/or
wherein the layer of ohmic heating material (25) has a thickness between 0.01 mm to 10 mm.

Example 4. The superconductor cable (21) of any of examples 1 to 3,
wherein, when from a first position along the superconductor cable to a second position along the superconductor cable the high temperature superconductor material is in a non-superconducting state, the superconductor cable (21) has:
a first resistance, Rnz, determined for current passing through the superconductor region from the first position to the second position and
a second resistance, Rbypass, determined for current not passing through the superconductor region from the first position to the second position;
and wherein a ratio Rnz to Rbypass is at least 1.

Example 5. The superconductor cable (21) of any of examples 2 to 4, further comprising:
a layer of insulation material (27) at least partially surrounding the layer of second metallic stabilizer material (26), wherein the layer of insulation material (27) has a resistivity of at least 1 ·10⁴ Ohm · m.

Example 6. The superconductor cable (21) of any of examples 1 to 5, wherein the superconductor cable (21) further comprises:
at least one second high temperature superconductor material, optionally at least one second stack of high temperature superconductor tapes (23b) and/or
at least one third high temperature superconductor material, optionally at least one third stack of high temperature superconductor tapes (23c); and/or
at least one fourth high temperature superconductor material, optionally at least one fourth stack of high temperature superconductor tapes (23d);
wherein, optionally, the high temperature superconductor material, the at least one second high temperature superconductor material, the at least one third high temperature superconductor material and/or the at least one fourth high temperature superconductor material are one or more of the following:
   electrically insulated from each other,
   electrically connected with each other,
   connected by a third metallic stabilizer material (24c),
   at least partially or entirely surrounded by the layer of ohmic heating material (25).

Example 7. The superconductor cable (21) of any of examples 1 to 6, wherein the high temperature superconductor material (23) and/or the at least one second high temperature superconductor material and/or the at least one third high temperature superconductor material and/or the at least one fourth high temperature superconductor material is twisted along a length of the superconductor cable (21).

Example 8. The superconductor cable (21) of any of examples 1 to 7, wherein the first metallic stabilizer material (24) further comprises a metallic jacket layer (24b).

Example 9. The superconductor cable (21) of any of examples 1 to 8, wherein along a length (LD) of the superconductor cable (21):
the resistivity of the ohmic heating material (25) changes and/or
a local thickness of the ohmic heating material (25) changes.

Example 10. The superconductor cable of example 9, wherein the local thickness and/or resistivity of the ohmic heating material (25) in a region at the start (R1) along the length of the superconductor cable (21) and/or in a region at the end (R2) along the length of the superconductor cable (21) are different from the local thickness and/or resistivity of the ohmic heating material in a region in the middle (R3) along the length of the superconductor cable.

Example 11. The superconductor cable (21) of any of examples 1 to 10, wherein
the first metallic stabilizer material (24) comprises at least one of the following materials: solder, copper, copper alloy, brass, aluminium, aluminium alloy and/or
the layer of ohmic heating material (25) comprises at least one of the following materials:silicon carbide, semi-metals, semiconductors, anodised aluminium, matrix composites and/or
the layer of second metallic stabilizer (26) material comprises at least one of the following materials: solder, copper, copper alloy, brass, aluminium or aluminium alloy, a high-strength material, steel; and/or
the optional layer of insulation material (27) comprises at least one of the following materials: organic insulators, polyimide, inorganic insulators, ceramic, non-conductive epoxy, a glass fibre matrix, insulation paper, insulating lacquer, paint.

Example 12. A superconductor cable assembly (22), preferably a superconductor magnetic field coil (20, 20a, 20b), comprising a plurality of turns (31, 32, 33) of a superconductor cable (21) and/or a plurality of superconductor cables (21, 41, 42) according to any of examples 1 to 11.

Example 13. A superconductor cable assembly (22) comprising at least one superconductor cable (21), the at least one superconductor cable (21) comprising:
a superconductor region, the superconductor region comprising:
high temperature superconductor material, optionally high temperature superconductor tapes (23) and
a first metallic stabilizer material (24); the superconductor cable further comprising:
   a layer of ohmic heating material (25) at least partially surrounding the superconductor region;
the superconductor cable assembly (22) further comprising:
a layer of second metallic stabilizer material (26) at least partially or entirely surrounding the layer of ohmic heating material (25);
wherein a thickness and resistivity of the layer of ohmic heating material (25) are configured such that a first velocity (v1) of a non-superconducting zone propagation along the superconductor cable (21) is larger than a second velocity (v2) of non-superconducting zone propagation in a radial direction of the superconductor cable assembly (22).

Example 14. The superconductor cable assembly (22) of example 13, wherein the superconductor cable assembly (22) is a magnetic field coil (20, 20a, 20b) comprising a plurality of turns (31, 32, 33) of the at least one superconductor cable (21) and/or wherein the radial direction of the superconductor cable assembly (22) is a direction perpendicular to a local direction along at least one of the plurality of turns (31, 32, 33).

Example 15. The superconductor cable assembly (22) of example 14,
wherein a ratio of the first velocity (v1) to the second velocity (v2) is configured such that a locally formed non-superconducting zone (50) in one of the turns (31, 32, 33) of the plurality of turns propagates along a substantial distance of the turn before an adjacent turn becomes non-superconducting.

Example 16. The superconductor cable assembly (22) of any of examples 12 to 15, wherein the superconductor cable assembly (22) further comprises:
a layer of insulation material (27) surrounding the layer of second metallic stabilizer material (26), wherein the layer of insulation material (27) has a resistivity of at least 1 · 10⁴ Ohm · m.

Example 17. The superconductor cable assembly (22) of any of examples 12 to 16, wherein the second metallic stabilizer (26) further comprises a conductive support structure (26a), wherein:
the superconductor cable is embedded in the conductive support structure (26a) and/or
the conductive support structure (26a) comprises at least one of the following materials: stainless steel, titanium, composite carbon fibre, inconel, nitronic alloy, high strength alloys.

Example 18. The superconductor cable assembly (22) of any of examples 12 to 17, wherein the superconductor cable assembly (22) is a planar magnetic field coil (20a) or a non-planar magnetic field coil (20b) for a stellarator (1).

Example 19. System (100) for preventing damage to at least one superconductor cable assembly (22) of any of examples 12 to 18, the system comprising:
at least one sensor (110) connected to the at least one superconductor cable assembly (22);
   a power control unit (130) connected to the at least one superconductor cable assembly (22);
at least one non-superconducting zone generation means (140) connected to the at least one superconductor cable assembly (22);
   optionally, a dump circuitry (150);and
a control unit (120), operably connected to the at least one sensor (110), the power control unit (130),the at least one non-superconducting zone generation means (140) and optionally connected to the dump circuitry (150), the control unit (120) configured to:
   determine that a local non-superconducting zone (50) has developed in at least one of the at least one superconductor cable assembly (22) based on the at least one sensor (110);
   optionally, interrupt a connection to a power control unit (130) of the at least one superconductor cable assembly (22);
   optionally, activate the non-superconducting zone generation means (140) to generate at least one additional non-superconducting zone in the at least one superconductor cable assembly (22), and
   optionally, connect a dump circuitry (150) to the at least one superconductor cable assembly (22).

Example 20. The system of example 19, wherein the non-superconducting zone generation means (140) is at least one of the following:
at least one heating element attached to the at least one superconductor cable assembly (22)
at least one alternating current generation means coupled to the at least one superconductor cable assembly (22),
and wherein the control unit (120) is further configured to:
activate the at least one heating element and/or the at least one alternating current generation means to generate the at least one additional non-superconducting zone.

Example 21. A method (1200) for preventing damage to at least one superconductor cable assembly (22), comprising the following steps:
determining (S1) that a local non-superconducting zone (50) has developed in the at least one superconductor cable assembly (22);
interrupting (S2) a connection of a power control unit (130) with the at least one superconductor cable assembly (22);
optionally, activating (S3) a non-superconducting zone generation means (140) to generate at least one additional non-superconducting zone;
optionally, connecting (S4) a dump circuitry (150) to the at least one superconductor cable assembly (22).

Example 22. The method of example 21, wherein the non-superconducting zone generation means (140) is at least one of the following:
at least one heating element (140) attached to the at least one superconductor cable assembly (22),
at least one alternating current generation means coupled to the at least one superconductor cable assembly (22).

Example 23. The method of example 21 or example 22, wherein the at least one superconductor cable assembly (22) comprises a plurality of superconductor cable assemblies and wherein the method further comprises:
in response to the determining that a local non-superconducting zone (50) has developed in the at least one superconductor cable assembly (22):
performing at least one of the steps of interrupting, activating and connecting for all of the plurality of superconductor cable assemblies.

Example 24. A superconductor cable (21) for a superconductor cable assembly (22), comprising:
a superconductor region, the superconductor region comprising:
high temperature superconductor material, optionally high temperature superconductor tapes (23) and
a first metallic stabilizer material (24); the superconductor cable further comprising:
   a layer of ohmic heating material (25) at least partially surrounding the superconductor region.

Example 25. The superconductor cable (21) of example 24, wherein
the layer of ohmic heating material (25) has a surface resistivity between 10⁻⁷ Ohm·m² and 1 Ohm·m², optionally between 10⁻⁷ Ohm·m² and 1 Ohm·m², optionally between 10⁻⁶ Ohm·m² and 10⁻¹ Ohm·m², optionally between 10⁻⁵ Ohm·m² and 10⁻² Ohm·m², optionally between 10⁻⁴ Ohm·m² and 10⁻³ Ohm·m², optionally between 2 · 10⁻⁴ Ohm·m² and 5 · 10⁻⁴ Ohm·m², optionally of approximately 3 · 10⁻⁴ Ohm·m²; and/or
   and/or
wherein the layer of ohmic heating material (25) has a surface resistivity between 10⁻⁷ Ohm·m² and 3·10⁻⁴ Ohm m², optionally between 5 ·10⁻⁷ Ohm·m² and 1.5 · 10⁻⁴ Ohm·m², optionally between 1 · 10⁻⁶ Ohm·m² and 7.5 · 10⁻⁵ Ohm·m², optionally between 5 · 10⁻⁶ Ohm·m² and 3 · 10⁻⁵ Ohm·m², optionally between 10⁻⁵ Ohm·m² and 1.5 · 10⁻⁵ Ohm·m², optionally between 3 · 10⁻⁵ Ohm·m² and 1 · 10⁻⁵ Ohm·m²
   and /or
wherein the layer of ohmic heating material (25) has a surface resistivity between 3 · 10⁻⁴ Ohm·m² and 1 Ohm·m², optionally between 1 · 10⁻³ Ohm·m² and 3 · 10⁻¹ Ohm·m², optionally between 3 · 10⁻³ Ohm·m² and 1 · 10⁻¹ Ohm·m², optionally between 1 · 10⁻² Ohm·m² and 3 · 10⁻² Ohm·m², optionally between 3 · 10⁻² Ohm·m² and 1 · 10⁻¹ Ohm·m², optionally between 1 · 10⁻¹ Ohm·m² and 3 · 10⁻¹ Ohm·m².

Example 26. The superconductor cable (21) of example 24 or 25, wherein the superconductor cable (21) further comprises features according to at least one of examples 2 to 11.

### Annex C

Example 1. A superconductor cable for a superconductor cable assembly comprises a superconductor region that includes high temperature superconductor material (optionally in the form of superconductor tapes) and a first metallic stabilizer material. The cable further includes a layer of ohmic heating material at least partially surrounding the superconductor region. This layer comprises a first material that exhibits a high resistivity at a first temperature and a low resistivity at a second temperature, where the second temperature is above the first.

Example 2. A superconductor cable according to Example 1, wherein the high resistivity is at least 1·10² Ω·cm and/or the low resistivity is at most 1·10⁻² Ω·cm.

Example 3. A superconductor cable according to any previous example, wherein the first material comprises a metal-insulator transition material.

Example 4. A superconductor cable according to any previous example, wherein the first material comprises a varistor material.

Example 5. A superconductor cable according to Example 3 or Example 4, wherein the first material comprises at least one of the following materials:
- Vanadium and oxygen
- VxOy
- V8O15
- Doping materials (optionally including chromium)
- V₂O₃
- Vanadium dioxide (optionally doped with additional elements, optionally including chromium)
- Titanium dioxide (optionally doped with additional elements)
- Nickel sulfide
- NBO₂
- BiFeO₃
- TixOy
- LuFe₄(CuO₄)₃
- CaFe₄(CuO₄)₃
- PrNiO₃
- Fe₃O₄
- CaFeO₃
- Sm(P₃Ru)₄
- NaOsO₃
- NdCoO₃
- Magnetite (Fe₃O₄)
- Samarium sulfide
- Lanthanum nickelate
- Zinc oxide
- Ceramic metal-oxides

Example 6. A superconductor cable according to any previous example, wherein the layer of ohmic heating material has a surface resistivity between 10⁷ Ω·m² and 1 Ω·m².

Example 7. A superconductor cable according to any previous example, further comprising a layer of second metallic stabilizer material. In this configuration, the layer of ohmic heating material is arranged at least partially or entirely between the superconductor region and the second metallic stabilizer material, and/or its surface resistivity is defined relative to these adjacent regions.

Example 8. A superconductor cable according to any previous example, wherein the layer of ohmic heating material entirely surrounds the superconductor region and/or is arranged between the superconductor region and the second metallic stabilizer material, and/or the layer has a thickness between 0.01 mm and 10 mm.

Example 9. A superconductor cable according to any previous example, wherein when a first section along the cable and a second section along the cable are in a non-superconducting state, the cable exhibits (a) a first resistance for current passing through the superconductor region and (b) a second resistance for current bypassing the superconductor region, with the ratio between these resistances being at least 1.

Example 10. A superconductor cable according to Examples 7 to 9, further comprising a layer of insulation material at least partially surrounding the layer of second metallic stabilizer material, wherein the insulation layer has a resistivity of at least 10⁴ Ω·m.

Example 11. A superconductor cable according to any previous example, wherein the cable - optionally including its superconductor region - further comprises at least one second high temperature superconductor material (optionally in the form of a second stack of superconductor tapes), at least one third high temperature superconductor material (optionally as a third stack of superconductor tapes), and/or at least one fourth high temperature superconductor material (optionally as a fourth stack of superconductor tapes). In these configurations, the various high temperature superconductor materials may be electrically insulated from one another, electrically connected, connected via a third metallic stabilizer material, at least partially or entirely surrounded by the layer of ohmic heating material, and/or twisted along the cable length.

Example 12. A superconductor cable according to any previous example, wherein along the cable length the resistivity and/or local thickness of the ohmic heating material varies. Alternatively, the local thickness and/or resistivity at the start and/or end of the cable may differ from those in the middle of the cable.

Example 13. A superconductor cable according to any previous example, wherein:
- The first metallic stabilizer material comprises at least one of the following: solder, copper, copper alloy, brass, aluminium, or aluminium alloy.
- The layer of ohmic heating material comprises at least one of the following: silicon carbide, semi-metals, semiconductors, anodised aluminium, or matrix composites.
- The layer of second metallic stabilizer material comprises at least one of the following: solder, copper, copper alloy, brass, aluminium, aluminium alloy, a high-strength material, or steel.
- The optional layer of insulation material comprises at least one of the following: organic insulators, polyimide, inorganic insulators, ceramic, non-conductive epoxy, a glass fibre matrix, insulation paper, insulating lacquer, or paint.

Example 14. A superconductor cable assembly, preferably serving as a superconductor magnetic field coil, comprising a plurality of turns of a superconductor cable and/or a plurality of superconductor cables as described in any of Examples 1 to 13.

Example 15. A superconductor cable assembly comprising at least one superconductor cable, wherein the cable comprises a superconductor region that includes high temperature superconductor material (optionally as superconductor tapes) and a first metallic stabilizer material, and further comprises a layer of ohmic heating material at least partially surrounding the superconductor region. The layer of ohmic heating material comprises a first material that has a high resistivity at a first temperature and a low resistivity at a higher second temperature. The assembly further includes a layer of second metallic stabilizer material at least partially or entirely surrounding the layer of ohmic heating material, with the thickness and resistivity of the ohmic heating material configured such that a first velocity of non-superconducting zone propagation along the cable exceeds a second velocity of non-superconducting zone propagation in a radial direction of the assembly.

Example 16. A superconductor cable assembly according to Example 15, wherein the high resistivity is at least 1·10² Ω·cm and/or the low resistivity is at most 1·10⁻² Ω·cm.

Example 17. A superconductor cable assembly according to Example 15 or Example 16, wherein the first material comprises a metal-insulator transition material.

Example 18. A superconductor cable assembly according to any previous example, wherein the first material comprises a varistor material.

Example 19. A superconductor cable assembly according to any previous example, wherein the first material comprises at least one of the following materials:
- Vanadium and oxygen
- VxOy
- V8O15
- Doping materials (optionally including chromium)
- V₂O₃
- Vanadium dioxide (optionally doped with additional elements and optionally including chromium)
- Titanium dioxide (optionally doped with additional elements)
- Nickel sulfide
- NBO₂
- BiFeO₃
- TixOy
- LuFe₄(CuO₄)₃
- CaFe₄(CuO₄)₃
- PrNiO₃
- Fe₃O₄
- CaFeO₃
- Sm(P₃Ru)₄
- NaOsO₃
- NdCoO₃
- Magnetite
- Samarium sulfide
- Lanthanum nickelate
- Zinc oxide
- Ceramic metal-oxides

Example 20. A superconductor cable assembly according to any previous example, wherein the assembly serves as a superconductor magnetic field coil (preferably a planar or a non-planar coil suitable for a stellarator). The assembly comprises a plurality of turns of at least one superconductor cable, and the radial direction of the assembly is defined as perpendicular to a local direction along at least one turn.

Example 21. A superconductor cable assembly according to any previous example, wherein the ratio of the first velocity (propagation speed of the non-superconducting zone along the cable) to the second velocity (propagation speed in the radial direction of the assembly) is configured so that a locally formed non-superconducting zone in one turn extends substantially along that turn before an adjacent turn becomes non-superconducting.

Example 22. A superconductor cable assembly according to any previous example further comprises a layer of insulation material that surrounds the layer of second metallic stabilizer material. In this configuration, the insulation material exhibits a resistivity of at least 1·10⁴ Ω·m.

Example 23. A superconductor cable assembly according to any previous example, wherein the second metallic stabilizer further comprises a conductive support structure. In this design, the superconductor cable is embedded within the conductive support structure and/or the conductive support structure comprises at least one of the following materials: Stainless steel, Titanium, Composite carbon fibre, Inconel, Nitronic alloy, High-strength alloys.

## Claims

1. A strand arrangement (1), optionally for a superconductor magnetic field coil (2, 2a, 2b), comprising:
- a first plurality of strands (10) of superconductor material, the first plurality of strands comprising:
a first strand (A, A1) of the first plurality of strands with a first end (Ab) and a second end (Ae),
a second strand (B, B1) of the first plurality of strands,
a first ohmic heating material (20) arranged between the first strand (A, A1) of the first plurality of strands and the second strand (B, B1) of the first plurality of strands,
a first insulation material (40, 40a) at least partially enclosing the first plurality of strands;
at least one of:
- an electrical series connection (31-39, 310, 311), connecting the second end (Ae) of the first strand (A, A1) of the first plurality of strands with an end of a further strand (B-H), or
- a first electrical series connection (31) connecting the second end (Ae) of the first strand (A, A1) of the first plurality of strands with a first end (Bb) of the second strand (B, B1) of the first plurality of strands.

2. The strand arrangement of claim 1, further comprising:
a third strand (C1) of the first plurality of strands,
wherein the first ohmic heating material (20) is arranged between the first strand (A1), the second strand (B1), and the third strand (C1) of the first plurality of strands,
a second electrical series connection (32) connecting a second end (Be) of the second strand (B, B1) of the first plurality of strands with a first end (Cb) of the third strand (C1) of the first plurality of strands.

3. The strand arrangement of claim 1 or claim 2, optionally comprising a first double pancake coil (2a), comprising:
- a second plurality of strands (11; C, D) of superconductor material, the second plurality of strands comprising:
a first strand (C) of the second plurality of strands and
a second strand (D) of the second plurality of strands,
a second ohmic heating material arranged between the first strand (C) of the second plurality of strands and the second strand (D) of the second plurality of strands,
a second insulation material (40b) at least partially enclosing the second plurality of strands;
wherein the electrical series connection is a third electrical series connection (33) and
wherein the further strand is a second end (Ce) of the first strand (C) of the second plurality of strands.

4. The strand arrangement of claim 3, further comprising at least one of:
- a fourth electrical series connection (34) connecting a second end (Be) of the second strand (B) of the first plurality of strands with a second end (De) of the second strand (D) of the second plurality of strands and/or
- a fifth electrical series connection (35) connecting a first end (Bb) of the second strand (B) of the first plurality of strands with a first end (Cb) of the first strand (C) of the second plurality of strands.

5. The strand arrangement of claim 4, optionally comprising a second double pancake coil (2b), the strand arrangement further comprising:
- a third plurality of strands (12; E, F) of superconductor material, the third plurality of strands comprising:
a first strand (E) of the third plurality of strands and
a second strand (F) of the third plurality of strands,
a third ohmic heating material (20) arranged between the first strand (E) of the third plurality of strands and the second strand (F) of the third plurality of strands,
a third insulation material (40c) at least partially enclosing the third plurality of strands;
- a fourth plurality of strands (13; G, H) of superconductor material, the fourth plurality of strands comprising:
a first strand (G) of the fourth plurality of strands and
a second strand (H) of the fourth plurality of strands,
a fourth ohmic heating material (20) arranged between the first strand (G) of the fourth plurality of strands and the second strand (H) of the fourth plurality of strands,
a fourth insulation material (40d) at least partially enclosing the fourth plurality of strands;
further comprising at least one of the following:
- a sixth electrical series connection (33b) connecting a second end (Ee) of the first strand (E) of the third plurality of strands with a second end (Ge) of the first strand (G) of the fourth plurality of strands, and/or
- a seventh electrical series connection (34b) connecting a second end (Fe) of the second strand (F) of the third plurality of strands with a second end (He) of the second strand (H) of the fourth plurality of strands and/or
- an eighth electrical series connection (35b) connecting a first end (Fb) of the second strand (F) of the third plurality of strands with a first end (Gb) of the first strand (G) of the fourth plurality of strands; and/or
- a ninth electrical series connection (39) connecting a first end (Db) of the second strand (D) of the second plurality of strands with a first end (Eb) of the first strand (E) of the third plurality of strands.

6. The strand arrangement of any one of the previous claims, optionally comprising a bus-bar arrangement, the strand arrangement further comprising:
- a tenth electrical series connection (310) connecting the second end (Ae) of the first strand (A, A1) of the first plurality of strands with a second end (Be) of the second strand (B1) of the first plurality of strands and/or
- an eleventh electrical series connection (311) connecting a first end (Bb) of the second strand (B1) of the first plurality of strands with a first end (Cb) of the third strand (C1) of the first plurality of strands.

7. The strand arrangement of any one of the previous claims, further comprising at least one of the following:
- a first metallic stabilizer material (25, 25a) extending along the first plurality of strands (10) and, optionally, wherein the first ohmic heating material (20) is arranged between the first plurality of strands (10) and the first metallic stabilizer material (25, 25a);
- a second metallic stabilizer material (25b) extending along the second plurality of strands (C, D), and, optionally, wherein the second ohmic heating material is arranged between the second plurality of strands and the second metallic stabilizer material (25b);
- a third metallic stabilizer (25c) material extending along the third plurality of strands (E, F), and, optionally, wherein the third ohmic heating material is arranged between the third plurality of strands and the third metallic stabilizer material (25c);
- a fourth metallic stabilizer material (25d) extending along the fourth plurality of strands (G,H), and, optionally, wherein the fourth ohmic heating material is arranged between the fourth plurality of strands and the fourth metallic stabilizer material (25d).

8. The strand arrangement of any one of the previous claims, wherein at least one of the first plurality of strands, the second plurality of strands, the third plurality of strands, and/or the fourth plurality of strands:
is arranged in at least one turn (50) and wherein, when the at least one turn comprises a plurality of turns, optionally, the plurality of turns comprises at least one of the following:
at least 3 turns,
at least 5 turns,
at least 10 turns
at least 20 turns,
at least 50 turns,
at least 100 turns,
at most 1000 turns.

9. The strand arrangement of any one of the previous claims, wherein at least one strand of the first plurality of strands, the second plurality of strands, the third plurality of strands, and/or the fourth plurality of strands is divided into a plurality of strand segments (A1-1, A1-2, A1-3), and, optionally, wherein the strand segments are connected with each other in a series connection to form the strand,
wherein, in case the strand arrangement includes at least one turn (50), the strand segments are connected by joints (60) and/or series connections between turns of the at least one turn (50).

10. The strand arrangement of any one of the previous claims, wherein at least one of the first, second, third, fourth, fifth, sixth, seventh, eighth, ninth, tenth, and/or eleventh electrical series connection:
- has a first resistance below 1 µOhm, preferably below 50 nOhm, preferably below 10 nOhm and/or
- has a first resistance value at least 10 times lower, optionally 100 times lower, optionally at least 1,000 times lower, than the resistance between two strands of the respective plurality of strands.

11. The strand arrangement of any one of claims 7 to 10, wherein at least one of the first, second, third, and/or fourth metallic stabilizer material is at least one of the following:
- arranged along a coil, inductively coupled to its corresponding plurality of strands;
- arranged to form a loop (26, 26a, 26b) between a first end of a coil and a second end of the coil;
- arranged in a closed loop within a single turn of the at least one turn (50);
- connected in series (27a, 27b) between the at least one turn (50a) and a second turn (50b), wherein, optionally, the second turn (50b) is a turn of at least one turn (50b) of the second plurality of strands;
- configured to form a loop over the at least one turn and the second turn.

12. The strand arrangement of any one of the previous claims, wherein at least one of the first, the second, the third and/or the fourth plurality of strands comprises:
- between 2 and 4 strands; or
- between 4 and 6 strands; or
- between 6 and 8 strands; or
- between 8 and 10 strands.

13. The strand arrangement according to any one of claims 1 to 12, wherein the superconductor material comprises a high temperature superconductor material, optionally a high temperature superconductor tape, optionally rare earth barium copper oxide, ReBCO, tape.

14. A superconductor magnetic field coil, comprising:
at least one insulated plurality of superconductor strands arranged in at least one turn,
wherein each plurality of the at least one insulated plurality of superconductor strands is electrically connected in series by low-resistance inter-strand joints, such that the at least one insulated plurality of superconductor strands behaves as a non-insulated, NI, coil with a number of turns corresponding to the number of strands connected in series and/or
at least one ohmic heating material arranged between the at least one insulated plurality of superconductor strands and at least one metallic stabilizer material, wherein the at least one ohmic heating material and the at least one metallic stabilizer material provide an ohmic heating path along the at least one insulated plurality of superconductor strands and/or comprising a strand arrangement according to any one of the previous claims,
and/or wherein the at least one metallic stabilizer material comprises at least one of the following:
- connections formed by the at least one metallic stabilizer material between a first and a second end of the superconductor magnetic field coil;
- at least one closed loop of the at least one metallic stabilizer material within a single turn of the at least one turn;
- at least one set of metallic stabilizer material, each set of the at least one metallic stabilizer material arranged with one of the at least one insulated plurality of superconductor strands to form at least one resistive coil inductively coupled to the at least one insulated plurality of superconductor strands;
- connections between a first set or all of the at least one set of metallic stabilizer material and a second set or all of the at least one metallic stabilizer material.

15. The strand arrangement and/or superconductor magnetic field coil according to any one of the previous claims, wherein at least one of the ohmic heating material, the second ohmic heating material, the third ohmic heating material, the fourth ohmic heating material, and/or additional ohmic heating material has a surface resistivity between 10⁻⁷ Ohm·m² and 1 Ohm·m².
